# EUROPEAN PATENT SPECIFICATION

(11) **EP 3 918 648 B1**
(45) Date of publication and mention of the grant of the patent: **24.08.2022**
(21) Application number: 20705810.8
(22) Date of filing: 30.01.2020
(51) Int. Cl.: H01L 51/42, H01L 51/46, H01L 51/00

(54) **PHOTOELECTRIC CONVERSION ELEMENT, SOLAR CELL MODULE, POWER SUPPLY MODULE, AND ELECTRONIC DEVICE**
ELEMENT ZUR FOTOELEKTRISCHEN UMWANDLUNG, SOLARZELLENMODUL, STROMVERSORGUNGSMODUL UND ELEKTRONISCHE VORRICHTUNG
ÉLÉMENT DE CONVERSION PHOTOÉLECTRIQUE, MODULE DE CELLULE SOLAIRE, MODULE D'ALIMENTATION ÉLECTRIQUE ET DISPOSITIF ÉLECTRONIQUE

(30) Priority: 01.02.2019 JP 2019016966
(43) Date of publication of application: 08.12.2021
(73) Proprietor: Ricoh Company, Ltd., Tokyo 143-8555 (JP)
(72) Inventor: TANAKA, Yuuji, Tokyo 143-8555 (JP); HORIUCHI, Tamotsu, Tokyo 143-8555 (JP); TAMOTO, Nozomu, Tokyo 143-8555 (JP); KANEI, Naomichi, Tokyo 143-8555 (JP); IDE, Takahiro, Tokyo 143-8555 (JP); HONDA, Tetsuya, Tokyo 143-8555 (JP); SHIBA, Masana, Tokyo 143-8555 (JP)
(74) Representative: Marks & Clerk LLP
(86) International application number: PCT/JP2020/003486
(87) International publication number: WO 2020/158876

(56) References cited:
- WO-A1-02/05354
- CN-A- 108 365 103
- US-A1- 2014 339 532

## Description

### Technical Field

The present disclosure relates to a photoelectric conversion element, a solar cell module, a power supply module, and an electronic device.

### Background Art

In recent years, solar cells using a photoelectric conversion element have been expected to be widely applied not only in terms of alternative to fossil fuels and measures against global warming but also as self-supporting power supplies that require neither replacement of battery nor power source wirings. The solar cells as the self-supporting power supplies attract much attention as one of energy harvesting techniques required in IoT (internet of things) devices etc.

Moreover, solar cells using photoelectric conversion elements that can efficiently generate power even with light of low illuminance and can be used indoor have recently been developed. As a photoelectric conversion element used indoor, for example, a solar cell using amorphous silicon or a photosensitizing compound has been known. Among them, a dye-sensitized solar cell using a photosensitizing compound is advantageous in view of production cost saving because it can be produced by a printing means known in the art.

As dye-sensitized solar cells, a solid photoelectric conversion element that suppresses a reduction in voltage and can obtain high output in an environment of high temperature or weak indoor light has been known (see, for example, PTL 1). PTL 2 and 3 disclose the use of iodonium compounds as dopants in the hole transporting layer of electronic devices such as solar cells. PTL 4 discloses the use of molten salts in dye sensitized solar cells.

### Citation List

### Patent Literature

PTL 1: Unexamined Japanese Patent Application Publication No. 2018-113305
PTL 2: US 2014/339532 A1
PTL 3: CN 108 365 103 A
PTL 4: WO 02/05354 A1

### Summary of Invention

### Technical Problem

The present disclosure has an object to provide a photoelectric conversion element that can suppress a reduction in output with light of low illuminance even after being exposed to light of high illuminance.

### Solution to Problem

According to one aspect of the present disclosure, a photoelectric conversion element includes a first electrode, an electron-transporting layer, a hole-transporting layer, and a second electrode, wherein the hole-transporting layer includes a hole-transporting material, an alkali metal salt, and a hypervalent iodine compound.

### Advantageous Effects of Invention

The present disclosure can provide a photoelectric conversion element that can suppress a reduction in output with light of low illuminance even after being exposed to light of high illuminance.

### Brief Description of Drawings

[fig.1]FIG. 1 is a schematic view illustrating an example of the photoelectric conversion element of the present disclosure.
[fig.2]FIG. 2 is a schematic view illustrating another example of the photoelectric conversion element of the present disclosure.
[fig.3]FIG. 3 is a schematic view illustrating another example of the photoelectric conversion element of the present disclosure.
[fig.4]FIG. 4 is a schematic view illustrating another example of the photoelectric conversion element of the present disclosure.
[fig.5]FIG. 5 is a schematic view illustrating an example of the solar cell module of the present disclosure.
[fig.6]FIG. 6 is a schematic view illustrating another example of the solar cell module of the present disclosure.
[fig.7]FIG. 7 is a schematic view illustrating another example of the solar cell module of the present disclosure.
[fig.8]FIG. 8 is a schematic block diagram illustrating a case where a mouse is used as an example of the electronic device of the present disclosure.
[fig.9]FIG. 9 is a schematic view illustrating an example of a mouse having the photoelectric conversion element.
[fig.10]FIG. 10 is a schematic block diagram illustrating a case where a keyboard is used as an example of the electronic device of the present disclosure.
[fig.11]FIG. 11 is a schematic view illustrating an example of a keyboard having the photoelectric conversion element.
[fig.12]FIG. 12 is a schematic view illustrating an example where the small photoelectric conversion element is disposed part of keys of a keyboard.
[fig.13]FIG. 13 is a schematic block diagram illustrating a case where a sensor module is used as an example of the electronic device of the present disclosure.
[fig.14]FIG. 14 is a schematic block diagram illustrating a case where a turntable is used as an example of the electronic device of the present disclosure.
[fig.15]FIG. 15 is a schematic block diagram illustrating an example of the electronic device including, in combination, the photoelectric conversion element or solar cell module of the present disclosure or both, and a device driven by electricity (power) generated by the photoelectric conversion element or solar cell module, or both.
[fig.16]FIG. 16 is a schematic block diagram illustrating an example where a power supply IC is incorporated between the photoelectric conversion element and a device circuit in FIG. 15.
[fig.17]FIG. 17 is a schematic block diagram illustrating an example where a power storage device is incorporated between the power supply IC and the device circuit in FIG. 16.
[fig.18]FIG. 18 is a schematic block diagram illustrating an example of the power supply module including the photoelectric conversion element of the present disclosure or a solar cell module, or both, and a power supply IC.
[fig.19]FIG. 19 is a schematic block diagram illustrating an example of the power supply module further including a power storage device in FIG. 18.

### Description of Embodiments

### (Photoelectric conversion element)

The photoelectric conversion element of the present disclosure includes at least a first electrode, an electron-transporting layer, a hole-transporting layer, and a second electrode. The hole-transporting layer includes at least a hole-transporting material, an alkali metal salt, and a hypervalent iodine compound.

The photoelectric conversion element of the present disclosure has been accomplished based on the following insight. That is, a photoelectric conversion element known in the art may significantly reduce output thereof with light of low illuminance, such as indoor light, after being exposed to light of high illuminance, such as sun light. More specifically, when a photoelectric conversion element known in the art is exposed to light of high illuminance to transmit a large quantity of electric current, charge may be accumulated because the photoelectric conversion element does not have a sufficient capability of transporting charge. In this case, leakage or recombination occurs in the photoelectric conversion element as charge is accumulated, and therefore output is significantly reduced with light of low illuminance.

The inventors of the present disclosure have found that the above-described problems are caused by an oxidizing agent used when an electron-accepting compound in a photoelectric conversion element is formed.

An electron-accepting compound in a photoelectric conversion element is formed by mixing a hole-transporting compound and an oxidizing agent in the presence of an alkali metal salt. In the art, a trivalent cobalt complex material is used as an oxidizing agent for forming an electron-accepting compound.

Since the trivalent cobalt complex material is an extremely large molecule, the trivalent cobalt complex material is difficult to stay in pores (fine voids) of an electron-transporting layer, such as in the case where a photoelectric conversion element has a porous electron-transporting layer. In the case where a trivalent cobalt complex material is used as an oxidizing agent, therefore, an electron-accepting compound is not sufficiently formed. Accordingly, a capability of a charge-transporting layer to transfer charge is insufficient, leakage or recombination occurs when exposed to light of high illuminance, and therefore output with light of low illuminance may be significantly decreased.

The photoelectric conversion element of the present disclosure includes at least a first electrode, an electron-transporting layer, a hole-transporting layer, and a second electrode, where the hole-transporting layer includes a hole-transporting material, an alkali metal salt, and a hypervalent iodine compound. Since the hypervalent iodine compound functioning as an oxidizing agent is a small molecule compared to a molecule of a trivalent cobalt complex material, the hypervalent iodine compound is readily present in pores of an electron-transporting layer. In the photoelectric conversion element of the present disclosure, therefore, an electron-accepting compound is sufficiently formed even in pores of the electron-transporting layer. Therefore, the capability of the charge-transporting layer to transport charge improves. As a result, the photoelectric conversion element of the present disclosure can suppress a reduction in output thereof with light of low illuminance even after being exposed to light of high illuminance.

The photoelectric conversion element is an element that can convert light energy to electrical energy. For example, the photoelectric conversion element can be applied for a solar cell, a power supply module, an electronic device, etc.

The photoelectric conversion element of the present disclosure includes a first electrode, an electron-transporting layer, a hole-transporting layer, and a second electrode, preferably further includes a hole-blocking layer, and more preferably further includes a first substrate, a second substrate, and a sealing member. The photoelectric conversion element may further include other members according to the necessity.

### <First electrode>

A shape and size of the first electrode are particularly limited and may be appropriately selected depending on the intended purpose.

A structure of the first electrode is not particularly limited and may be appropriately selected depending on the intended purpose. The structure of the first electrode may be a single layer structure or a structure where a plurality of materials are laminated.

A material of the first electrode is not particularly limited and may be appropriately selected depending on the intended purpose, as long as the material is a material having conductivity. Examples thereof include transparent conductive metal oxides, carbon, and metals.

Examples of the transparent conductive metal oxide include indium-tin oxide (referred to as "ITO" hereinafter), fluorine-doped tin oxide (referred to as "FTO" hereinafter), antimony-doped tin oxide (referred to as "ATO" hereinafter), niobiumdoped tin oxide (referred to as "NTO" hereinafter), aluminium-doped zinc oxide, indium-zinc oxide, and niobium-titanium oxide.

Examples of the carbon include carbon black, carbon nanotube, graphene, and fullerene.

Examples of the metal include gold, silver, aluminium, nickel, indium, tantalum, and titanium.

These may be used alone or in combination. Among them, transparent conductive metal oxide having high transparency is preferable, ITO, FTO, ATO, and NTO are more preferable.

An average thickness of the first electrode is not particularly limited and may be appropriately selected depending on the intended purpose. The average thickness of the first electrode is preferably 5 nm or more but 100 micrometers or less, more preferably 50 nm or more but 10 micrometers or less. When a material of the first electrode is carbon or metal, the average thickness of the first electrode is preferably an average thickness enough for obtaining translucency.

The first electrode can be formed by known methods such as sputtering, vapor deposition, and spraying.

Moreover, the first electrode is preferably formed on or above the below-described first substrate. It is possible to use an integrated commercially available product where the first electrode has been formed on the first substrate in advance.

Examples of the integrated commercially available product include FTO coated glass, ITO coated glass, zinc oxide/aluminium coated glass, an FTO coated transparent plastic film, and an ITO coated transparent plastic film. Other examples of the integrated commercially available product include glass substrates provided with a transparent electrode where tin oxide or indium oxide is doped with a cation or an anion having a different atomic value and glass substrates provided with a metal electrode having such a structure that allows light in the form of a mesh or stripes to pass.

These may be used alone, or two or more products may be used in combination as a combined product or a laminate. Moreover, a metal lead wire may be used in combination in order to decrease an electric resistance value.

A material of the metal lead wire is, for example, aluminium, copper, silver, gold, platinum, and nickel.

The metal lead wire is used in combination by forming it on the substrate through, for example, vapor deposition, sputtering, or pressure bonding, and disposing a layer of ITO or FTO thereon.

### <Hole-blocking layer>

The photoelectric conversion element of the present disclosure preferably includes a hole-blocking layer. The hole-blocking layer is preferably formed between the first electrode and the electron-transporting layer.

Since the photoelectric conversion element includes the hole-blocking layer, electrons generated by the photosensitizing compound and transported to the electron-transporting layer are transported to the first electrode, and can be prevented from being in contact with the hole-transporting layer. Therefore, the photoelectric conversion element including the hole-blocking layer can suppress the influx of holes into the first electrode and prevent a reduction in output thereof due to recombination between electrons and holes.

Since a solid photoelectric conversion element to which a hole-transporting layer is disposed has high speed of recombination between holes in the hole transport material and electrons on a surface of the electrode compared to a fluid-type photoelectric conversion element, an effect obtainable by the hole blocking layer is significant.

A material of the hole-blocking layer is not particularly limited and may be appropriately selected depending on the intended purpose, as long as the material is transparent to visible light and has electron-transporting properties. Examples thereof include: single semiconductors, such as silicon and germanium; compound semiconductors, such as metal chalcogenide; and compounds each having the Perovskite structure.

Examples of the metal chalcogenides include: oxides of titanium, tin, zinc, iron, tungsten, zirconium, hafnium, strontium, indium, cerium, yttrium, lanthanum, vanadium, niobium, and tantalum; sulfides of cadmium, zinc, lead, silver, antimony, and bismuth; selenides of cadmium and lead; and telluride of cadmium. Other examples of the compound semiconductor include: phosphides of zinc, gallium, indium, and cadmium; gallium arsenide; copper-indium-selenide; and copper-indium-sulfide.

Examples of the compound having the Perovskite structure include strontium titanate, calcium titanate, sodium titanate, barium titanate, and potassium niobate.

Among the above-listed examples, oxide semiconductors are preferable, titanium oxide, niobium oxide, magnesium oxide, aluminium oxide, zinc oxide, tungsten oxide, and tin oxide are even more preferable, and titanium oxide is more preferable

The above-listed examples may be used alone or in combination. Moreover, the above-listed examples may be formed as a single layer or a multiple layer. A crystal type of the above-listed semiconductors is not particularly limited and may be appropriately selected depending on the intended purpose. The crystal type thereof may be a single crystal, polycrystalline, or amorphous.

A film formation method of the hole-blocking layer is not particularly limited and may be appropriately selected depending on the intended purpose. Examples thereof include: wet film formation, such as a sol-gel method, and a hydrolysis method from titanium tetrachloride; and dry film formation, such as sputtering. Among the above-listed examples, sputtering is preferable. When the film formation method of the hole-blocking layer is sputtering, film density can be made sufficiently high and current loss can be prevented.

A film thickness of the hole-blocking layer is not particularly limited and may be appropriately selected depending on the intended purpose. The film thickness thereof is preferably 5 nm or greater but 1 micrometer or less. In the wet film formation, the film thickness thereof is more preferably 500 nm or greater but 700 nm or less. In the dry film formation, the film thickness thereof is more preferably 5 nm or greater but 30 nm or less.

### <Electron-transporting layer>

The electron-transporting layer is formed for the purpose of transporting electrons generated by the photosensitizing compound to the first electrode or the hole-blocking layer. Therefore, the electron-transporting layer is preferably disposed to be adjacent to the first electrode or the hole-blocking layer.

A shape and size of the electron-transporting layer are not particularly limited and may be appropriately selected depending on the intended purpose.

Moreover, a structure of the electron-transporting layer may be a continuous single layer or a multiple layer where a plurality of layers are laminated.

The electron-transporting layer includes an electron-transporting material, and may further include other materials according to the necessity.

The electron-transporting material is not particularly limited and may be appropriately selected depending on the intended purpose. The electron-transporting material is preferably a semiconductor material.

It is preferably that the semiconductor material be in the shape of particles, and a porous film thereof be formed by joining the particles together. Specifically, the electron-transporting layer is preferably a porous layer including titanium oxide particles on which a photosensitizing compound has been adsorbed. Since the photosensitizing compound is easily chemically or physically adsorbed on surfaces of semiconductor particles constituting the porous electron-transporting layer, output of the photoelectric conversion element can be improved.

The semiconductor material is not particularly limited and may be appropriately selected depending on the intended purpose. Examples thereof include single semiconductors, compound semiconductors, and compounds each having the Perovskite structure.

Examples of the single semiconductor include silicon and germanium.

Examples of the compound having the compound semiconductor include chalcogenide of metal. Specific examples thereof include: oxides of titanium, tin, zinc, iron, tungsten, zirconium, hafnium, strontium, indium, cerium, yttrium, lanthanum, vanadium, niobium, and tantalum; sulfides of cadmium, zinc, lead, silver, antimony, and bismuth; selenides of cadmium and lead; and telluride of cadmium. Other examples of the compound semiconductor include: phosphides of zinc, gallium, indium, and cadmium; gallium arsenide; copper-indium-selenide; and copper-indium-sulfide.

Examples of the compound having the Perovskite structure include strontium titanate, calcium titanate, sodium titanate, barium titanate, and potassium niobate.

Among the above-listed examples, oxide semiconductors are preferable, and titanium oxide, zinc oxide, tin oxide, and niobium oxide are particularly more preferable. When the electron-transporting material of the electron-transporting layer is titanium oxide, a conduction band is high and high open circuit voltage can be obtained. When the electron-transporting material of the electron-transporting layer is titanium oxide, a refractive index is high, ad high short-circuit current can be obtained owing to a light confinement effect. Moreover, use of titanium oxide as the electron-transporting material of the electron-transporting layer is advantageous because a dielectric constant is high and mobility is high thus a high fill factor can be obtained.

The above-listed examples may be used alone or in combination. A crystal type of the semiconductor material is not particularly limited and may be appropriately selected depending on the intended purpose. The crystal type thereof may be a single crystal, polycrystalline, or amorphous.

The number average particle diameter of primary particles of the semiconductor material is not particularly limited and may be appropriately selected depending on the intended purpose. The number average particle diameter thereof is preferably 1 nm or greater but 100 nm or less, and more preferably 5 nm or greater but 50 nm or less. Moreover, a semiconductor material having the lager particle size than the number average particle diameter may be mixed or laminated. Use of such a semiconductor material may improve a conversion efficiency owing to an effect of scattering incident light. In this case, the number average particle diameter is preferably 50 nm or greater but 500 nm or less.

The average thickness of the electron-transporting layer is not particularly limited and may be appropriately selected depending on the intended purpose. The average thickness thereof is preferably 50 nm or greater but 100 micrometers or less, more preferably 100 nm or greater but 50 micrometers or less, and even more preferably 120 nm or greater but 10 micrometers or less. When the average thickness of the electron-transporting layer is within the above-mentioned preferable range, an amount of the photosensitizing compound per unit projected area can be sufficiently secured, a capturing rate of light can be maintained high, a diffusion length of injected electrons is not easily increased, and loss due to recombination of charge can be maintained low. Therefore, the electron-transporting layer having the average thickness falling in the preferable range is advantageous.

A production method of the electron-transporting layer is not particularly limited and may be appropriately selected depending on the intended purpose. Examples of the production method thereof include a method where a thin film is formed in vacuum, such as sputtering, and a wet film forming method. Among the above-listed example, in view of a production cost, a wet film forming method is preferable, and a method where a paste in which powder or sol of a semiconductor material is dispersed is prepared, and the paste is applied onto a first electrode or a hole-blocking layer is more preferable.

The wet film formation method is not particularly limited and may be appropriately selected depending on the intended purpose. Examples thereof include dipping, spraying, wire-bar coating, spin coating, roller coating, blade coating, and gravure coating.

As a wet printing method, for example, various methods, such as relief printing, offset printing, gravure printing, intaglio printing, rubber plate printing, and screen printing, can be used.

A method for producing the dispersion liquid of the semiconductor material is not particularly limited and may be appropriately selected depending on the intended purpose. Examples thereof include a method where the semiconductor material is mechanically pulverized using a milling device known in the art. According to the method as mentioned, a particular semiconductor material alone or a mixture of the semiconductor material and a resin is dispersed in water or a solvent to thereby produce a dispersion liquid of the semiconductor material.

Examples of the resin include polymers or copolymers of vinyl compounds (e.g., styrene, vinyl acetate, acrylic acid ester, and methacrylic acid ester), silicone resins, phenoxy resins, polysulfone resins, polyvinyl butyral resins, polyvinyl formal resins, polyester resins, cellulose ester resins, cellulose ether resins, urethane resins, phenol resins, epoxy resins, polycarbonate resins, polyarylate resins, polyamide resins, and polyimide resins. The above-listed examples may be used alone or in combination.

The solvent is not particularly limited and may be appropriately selected depending on the intended purpose. Examples of the solvent include water, alcohol solvents, ketone solvents, ester solvents, ether solvents, amide solvents, halogenated hydrocarbon solvents, and hydrocarbon solvents.

Examples of the alcohol solvent include methanol, ethanol, isopropyl alcohol, and alpha-terpineol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

To the dispersion liquid including the semiconductor material or the paste including the semiconductor material obtained through the sol-gel method etc., acid, a surfactant, or a chelating agent may be added in order to prevent reaggregation of the particles.

Examples of the acid include hydrochloric acid, nitric acid, and acetic acid.

Examples of the surfactant include polyoxyethylene octylphenyl ether.

Examples of the chelating agent include acetyl acetone, 2-aminoethanol, and ethylene diamine.

Moreover, a thickener may be added for the purpose of improving film forming ability.

Examples of the thickener include polyethylene glycol, polyvinyl alcohol, and ethyl cellulose.

In order to make particles of the semiconductor material electrically connected with each other to improve a film strength or adhesion to a substrate after applying the semiconductor material, a firing treatment, a microwave or electron beam irradiation treatment, or a laser light irradiation treatment may be performed. The above-listed treatments may be performed alone or in combination.

In the case where the electron-transporting layer formed of the semiconductor material is fired, a firing temperature is not particularly limited and may be appropriately selected depending on the intended purpose. The firing temperature is preferably 30 degrees Celsius or higher but 700 degrees Celsius or lower, and more preferably 100 degrees Celsius or higher but 600 degrees Celsius or lower. Moreover, the firing duration is not particularly limited and may be appropriately selected depending on the intended purpose. The firing duration is preferably 10 minutes or longer but 10 hours or shorter.

In the case where the electron-transporting layer formed of the semiconductor material is irradiated with microwaves, irradiate duration is not particularly limited and may be appropriately selected depending on the intended purpose. The irradiation duration is preferably 1 hour or shorter. In this case, irradiation of microwaves may be performed from the side where the electron-transporting layer is formed, or from the side where the electron-transporting layer is not formed.

After firing the electron-transporting layer including the semiconductor material, for example, chemical plating using a titanium tetrachloride aqueous solution or a mixed solution with an organic solvent, or electrochemical plating using a titanium trichloride aqueous solution may be performed for the purpose of enhancing an electron injection efficiency from the photosensitizing compound to the semiconductor material.

The film obtained by firing the semiconductor material having a particle diameter of several tens nanometers can form a porous structure. Such a nanoporous structure has an extremely high surface area and the surface area can be represented by a roughness factor. The roughness factor is a numerical value representing an actual area of the inner side of pores relative to an area of the semiconductor particles applied onto the first substrate. Accordingly, the larger value of the roughness factor is more preferable. In view of a relationship with the average thickness of the electron-transporting layer, the roughness factor is preferably 20 or greater.

### «Photosensitizing compound»

A photosensitizing compound is adsorbed on a surface of the semiconductor material constituting the electron-transporting layer in order to further improve output or a photoelectric conversion efficiency.

The photosensitizing compound is not particularly limited and may be appropriately selected depending on the intended purpose, as long as the photosensitizing compound is a compound that is photoexcited by light emitted to the photoelectric conversion element. Examples of the photosensitizing compound include compounds known in the art below.

Specific examples of the photosensitizing compound include metal complex compounds, cumarin compounds disclosed in J. Phys. Chem. C, 7224, Vol. 111 (2007), polyene compounds disclosed in Chem. Commun., 4887 (2007), indoline compounds disclosed in J. Am. Chem. Soc., 12218, Vol. 126 (2004), Chem. Commun., 3036 (2003), and Angew. Chem. Int. Ed., 1923, Vol. 47 (2008), thiophene compounds disclosed in J. Am. Chem. Soc., 16701, Vol. 128 (2006), and J. Am. Chem. Soc., 14256, Vol. 128 (2006), cyanine dyes, merocyanine dyes, 9-arylxanthene compounds, triaryl methane compounds, phthalocyanine compounds and porphyrin compounds disclosed in J. Phys. Chem., 2342, Vol. 91 (1987), J. Phys. Chem. B, 6272, Vol. 97 (1993), Electroanal. Chem., 31, Vol. 537 (2002) J. Porphyrins Phthalocyanines, 230, Vol. 3 (1999), Angew. Chem. Int. Ed., 373, Vol. 46 (2007), and Langmuir, 5436, Vol. 24 (2008).

Among the above-listed examples, a metal complex compound, a cumarin compound, a polyene compound, an indoline compound, and a thiophene compound are preferable. The compounds represented by Structural Formulae (5), (6), and (7) below available from MITSUIBISHI PAPER MILLS LIMITED, and moreover a compound represented by General Formula (6) below are more preferable. The above-listed photosensitizing compounds may be used alone or in combination. 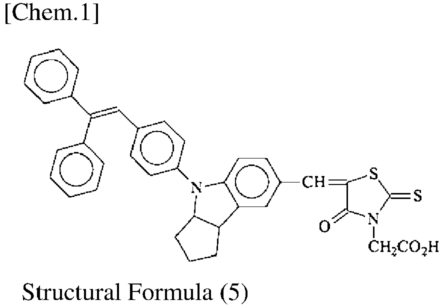 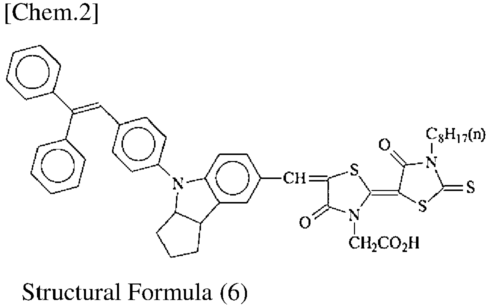 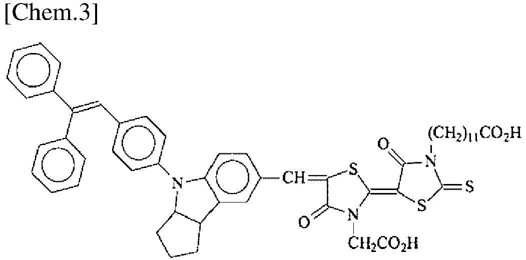 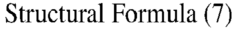 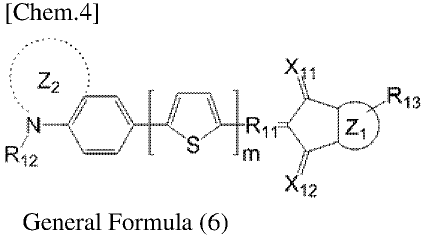 In General Formula (6), X₁₁ and X₁₂ are each an oxygen atom, a sulfur atom, and a selenium atom; R₁₁ is a methine group that may have a substituent, where specific examples of the substituent include an aryl group (e.g., a phenyl group and a naphthyl group) and a hetero cycle (e.g., a thienyl group and a furyl group); R₁₂ is an alkyl group that may have a substituent, an aryl group, or a heterocyclic group, where examples of the alkyl group include a methyl group, an ethyl group, a 2-propyl group, and a 2-ethylhexyl group, and examples of the aryl group and heterocyclic group includes the groups listed above; R₁₃ is an acid group, such as carboxylic acid, sulfonic acid, phosphonic acid, boronic acid, and phenols; Z₁ and Z₂ are each a substituent for forming a ring structure where examples of Z₁ include a condensation hydrocarbonbased compound (e.g., a benzene ring and a naphthalene ring) and a heteroring (e.g., a thiophene ring, and a furan ring) all of which may have a substituent, specific examples thereof include the above-listed alkyl group, and an alkoxy group (e.g., a methoxy group, an ethoxy group, and a 2-isopropoxy group), and examples of Z₂ include the following (A-1) to (A-22)); and m is 0 or 1.

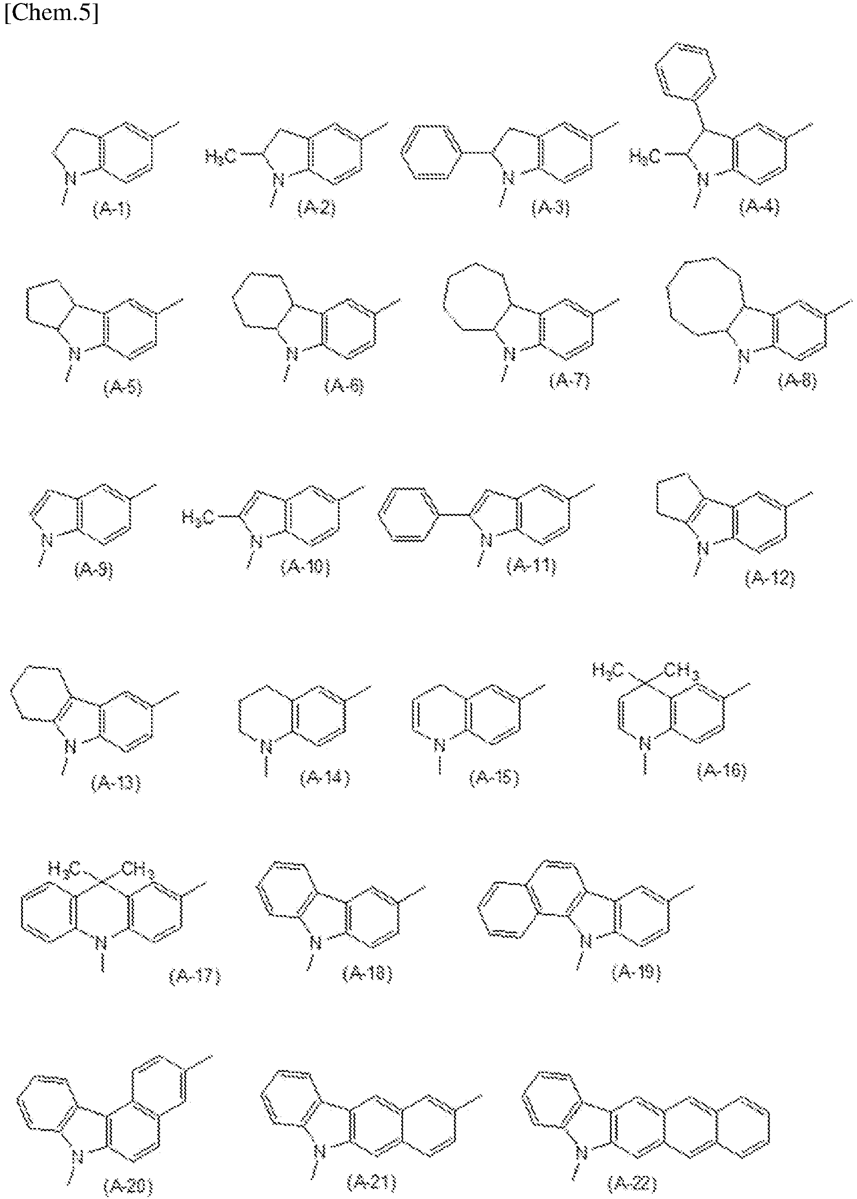

Specific examples of the photosensitizing compound represented by General Formula (6) include (B-1) to (B-36) below. However, the photosensitizing compound represented by General Formula (6) is not limited to these examples.

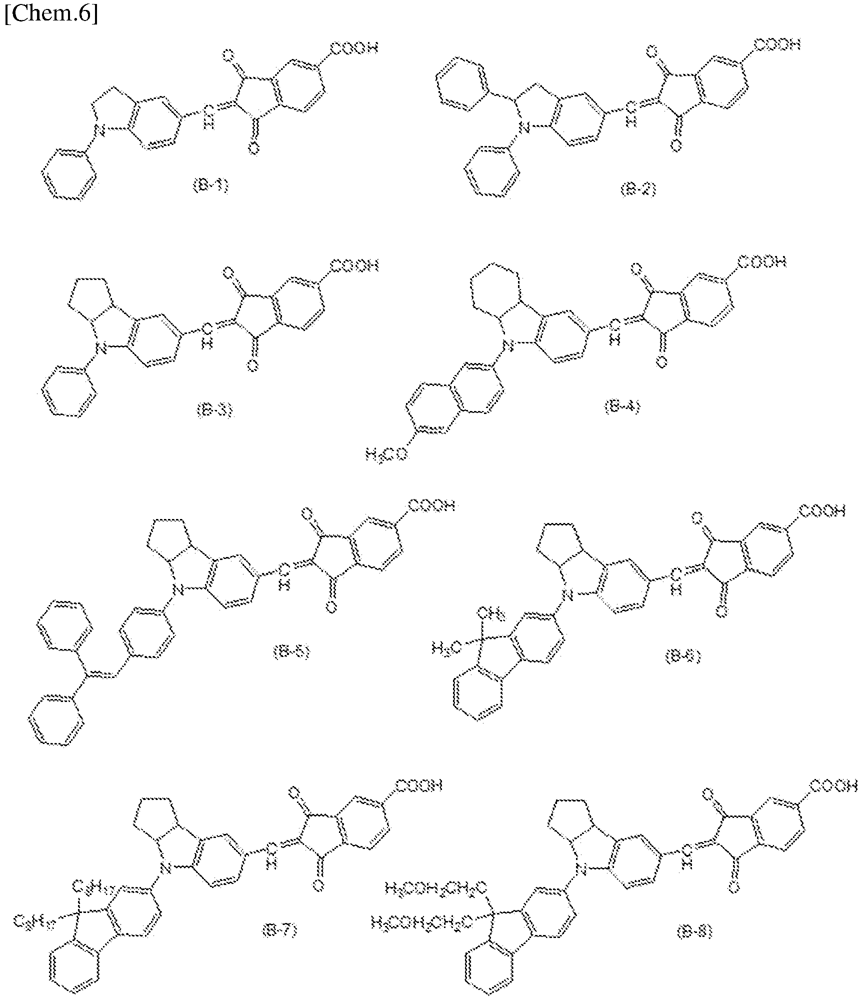

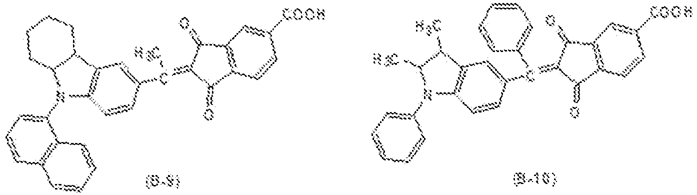

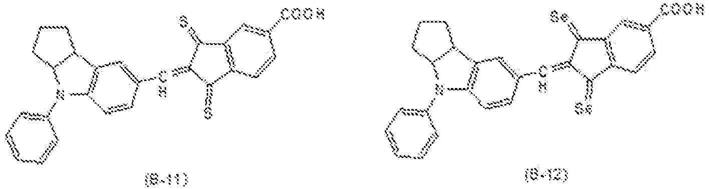

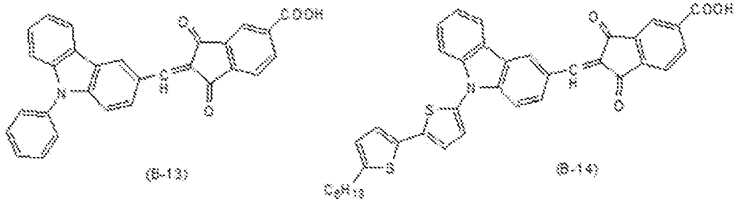

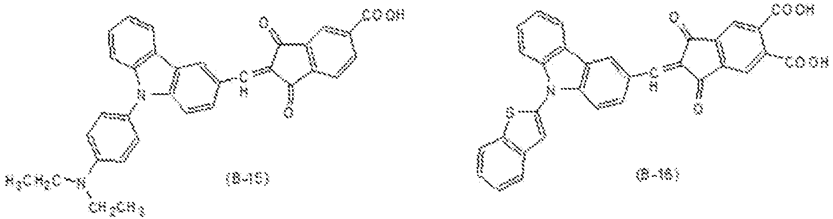

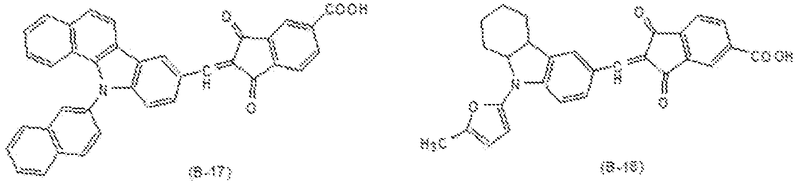

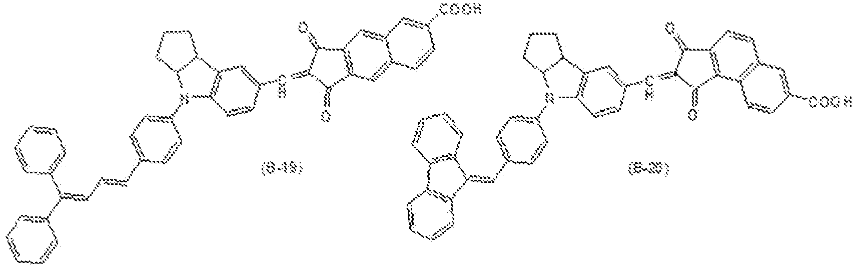

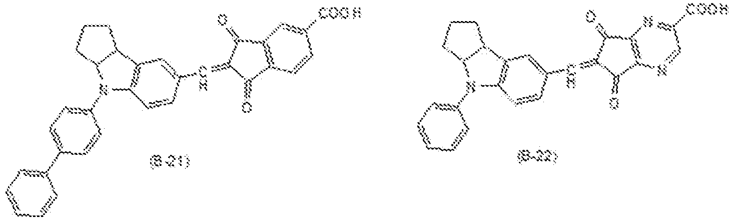

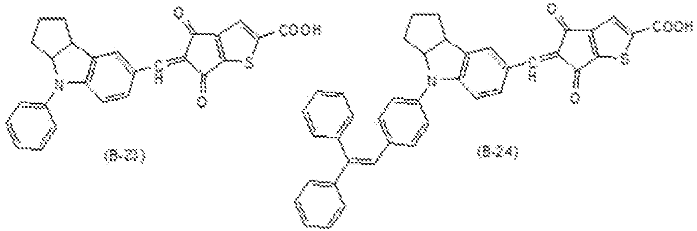

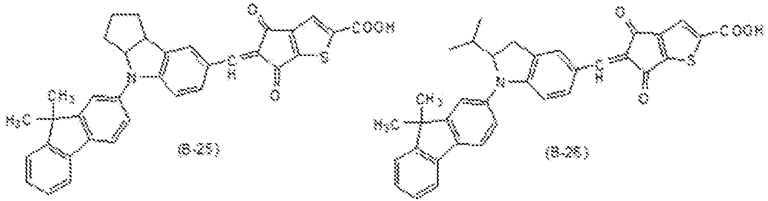

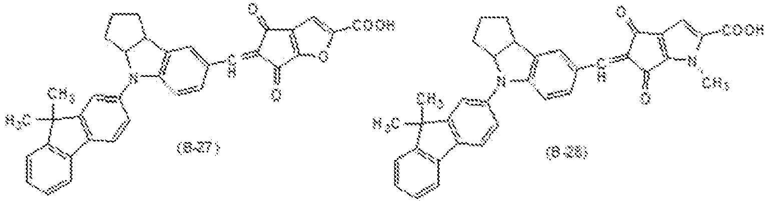

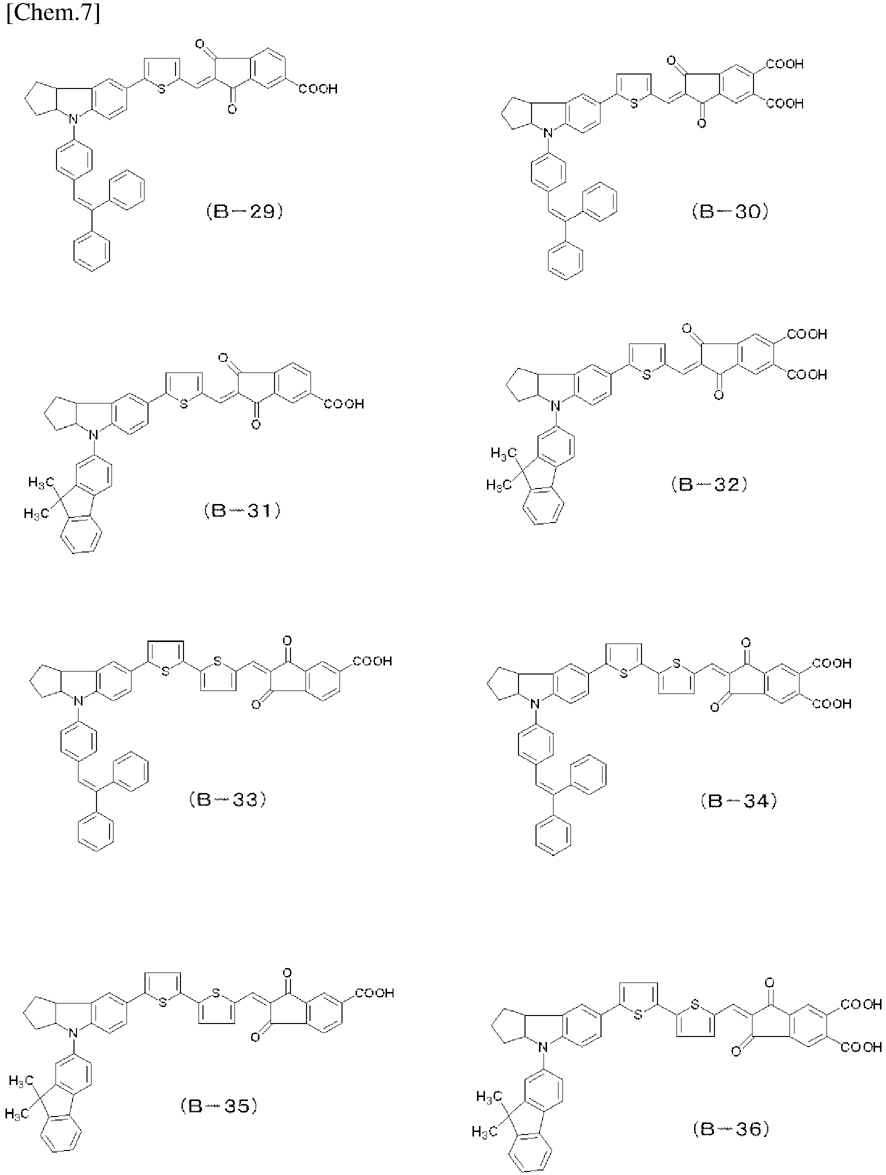

Moreover, a method for allowing the photosensitizing compound to be adsorbed on a surface of the semiconductor material of the electron-transporting layer is not particularly limited and may be appropriately selected depending on the intended purpose. Examples of the method for allowing the photosensitizing compound to be adsorbed on the semiconductor material of the electron-transporting layer include a method where the electron-transporting layer including the semiconductor material is immersed in a solution or dispersion liquid of the photosensitizing compound, and a method where a solution or dispersion liquid of the photosensitizing compound is applied onto the electron-transporting layer to adsorb the photosensitizing compound In case of the method of immersing the electron transport layer to which the semiconductor material is formed in a solution or dispersion liquid of the photosensitizing compound, an immersion method, a dipping method, a roller method, or an air knife method can be used.

In case of the method for applying a solution or dispersion liquid of the photosensitizing compound to the electron transport layer to make the photosensitizing compound adsorbed on the electron transport layer, wire bar coating, slide hopper coating, extrusion coating, curtain coating, spin coating, or spray coating can be used. Moreover, it is also possible to adsorb the photosensitizing compound on the electron transport layer in a supercritical fluid using carbon dioxide etc. In case of the method for applying a solution or dispersion liquid of the photosensitizing compound to the electron-transporting layer to make the photosensitizing compound adsorbed on the electron-transporting layer, wire bar coating, slide hopper coating, extrusion coating, curtain coating, spin coating, or spray coating can be used. Moreover, it is also possible to adsorb the photosensitizing compound on the electron-transporting layer in a supercritical fluid using carbon dioxide etc.

When the photosensitizing compound is adsorbed on the semiconductor material, a condensing agent may be used in combination.

The condensing agent is not particularly limited and may be appropriately selected depending on the intended purpose. Examples thereof include an agent that exhibits a catalytic function to physical or chemical bind a photosensitizing compound to a surface of a semiconductor material, and an agent that exhibits a stoichiometric function to move a chemical equilibrium advantageously. Moreover, thiol or a hydroxyl compound may be added as a condensation auxiliary.

The solvent for dissolving or dispersing the photosensitizing compound is not particularly limited and may be appropriately selected depending on the intended purpose. Examples of the solvent include water, alcohol solvents, ketone solvents, ester solvents, ether solvents, amide solvents, halogenated hydrocarbon solvents, and hydrocarbon solvents.

Examples of the alcohol solvent include methanol, ethanol, and isopropyl alcohol.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diethyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

Since there is a photosensitizing compound that may function more effectively when aggregations between compounds are prevented, depending on a kind of the photosensitizing compound for use, an aggregate dissociating agent may be used in combination.

The aggregate dissociating agent is not particularly limited and may be appropriately selected depending on a dye for use. The aggregate dissociating agent is preferable a steroid compound (e.g., cholic acid and chenodexycholic acid), long-chain alkyl carboxylic acid, or long-chain alkyl phosphonic acid.

An amount of the aggregate dissociating agent is preferably 0.01 parts by mass or greater but 500 parts by mass or less, and more preferably 0.1 parts by mass or greater but 100 parts by mass or less, relative to 1 part by mass of the photosensitizing compound.

A temperature at the time when the photosensitizing compound alone or a combination of the photosensitizing compound and the aggregate dissociating agent are adsorbed on a surface of the semiconductor material constituting the electron transport layer is preferably - 50 degrees Celsius or higher but 200 degrees Celsius or lower. The adsorption duration is preferably 5 seconds or longer but 1,000 hours or shorter, more preferably 10 seconds or longer but 500 hours or shorter, and even more preferably 1 minute or longer but 150 hours or shorter.

The process for adsorbing the photosensitizing compound or the aggregate dissociating agent onto the surface of the semiconductor material is preferably performed in the dark. Moreover, the process may be performed with still standing or with stirring.

A method for stirring is not particularly limited and may be appropriately selected depending on the intended purpose. Examples of the method include methods using a stirrer, a ball mill, a paint conditioner, a sand mill, Attritor, a disperser, and ultrasonic disperser.

### <Hole-transporting layer>

The hole-transporting layer is a layer configured to transport holes (positive holes) to the second electrode.

The hole-transporting layer includes a hole-transporting material, an alkali metal salt, and a hypervalent iodine compound. The hole-transporting layer may further include other components according to the necessity.

### «Hole-transporting material»

The hole-transporting material is not particularly limited and may be appropriately selected depending on the intended purpose, as long as the hole-transporting material is a material configured to transport holes (positive holes). The hole-transporting material is preferably an organic hole-transporting compound. The organic hole-transporting compound is preferably a compound having characteristics that the compound is a solid at a room temperature.

As the organic hole-transporting compound, organic hole-transporting compounds known in the art can be used. Examples thereof include an oxadiazole compound, a triphenylmethane compound, a pyrazoline compound, a hydrazine compound, a tetraarylbenzidine compound, a stilbene compound, and a spiro compound. Among the above-listed examples, a spiro compound is preferable.

The spiro compound is a compound represented by General Formula (7) below. 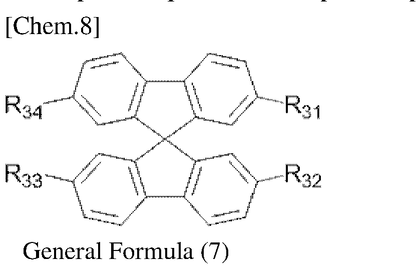 In General Formula (7), R₃₁ to R₃₄ are each a substituted amino group. Examples of the substituted amino group include a dimethylamino group, a diphenylamino group, and a naphthyl-4-tolylamino group.

The spiro compound is not particularly limited and may be appropriately selected depending on the intended purpose. Examples thereof include Exemplary Compounds (D-1) to (D-20) below, but not limited to these examples. The above-listed examples may be used alone or in combination.

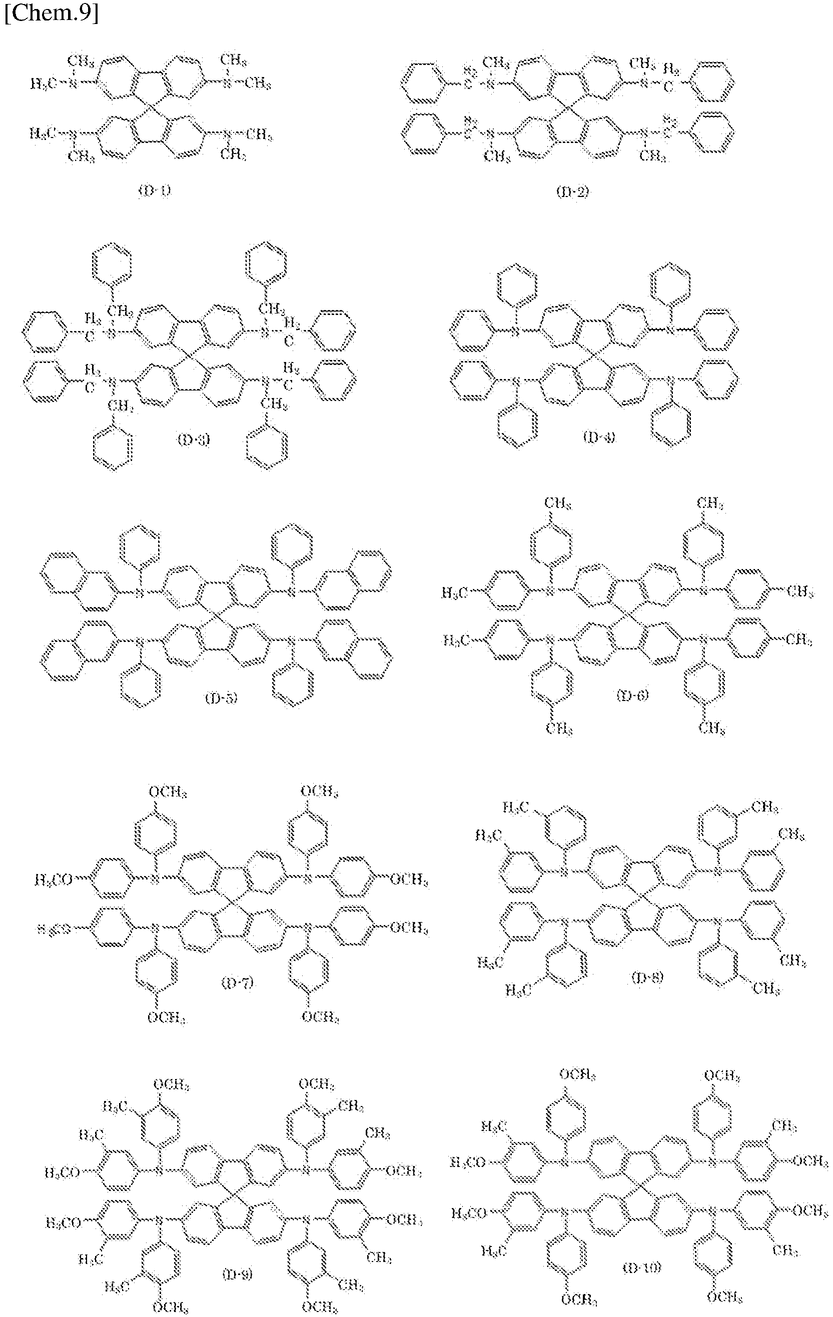

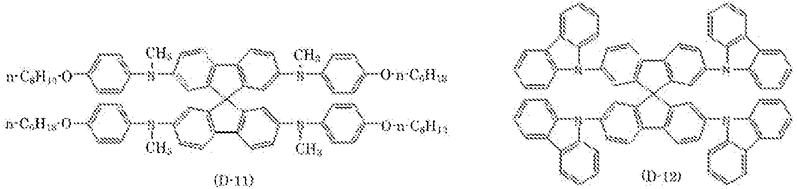

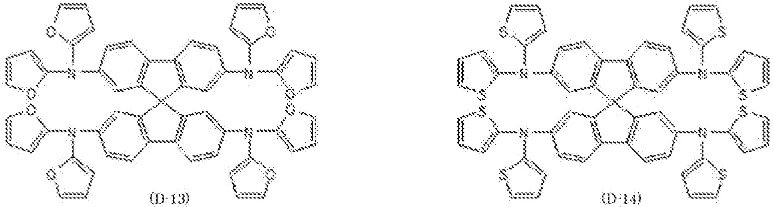

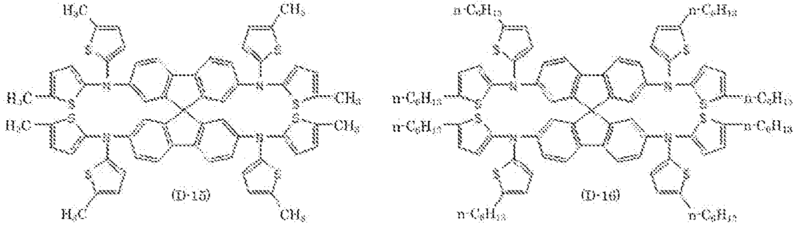

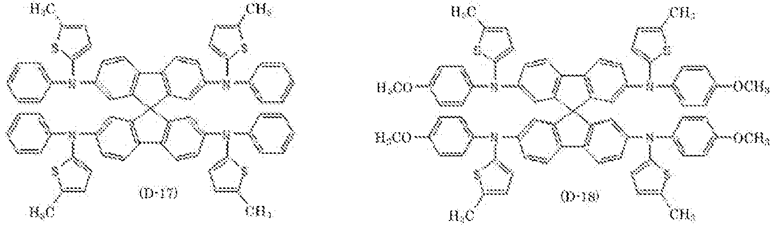

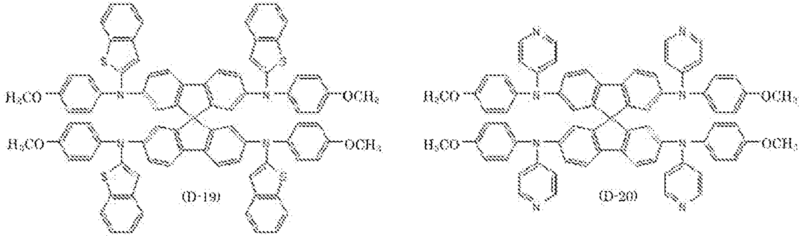

As well as the above-listed spiro compounds have high hole mobility, two benzidine skeletons are spirally bonded to form an electron cloud a shape of which is close to a sphere and hopping conductivity between molecules is excellent. Therefore, the spiro compounds exhibit excellent photoelectric conversion properties. Moreover, the spiro compounds are dissolved in various organic solvents because solubility of the spiro compounds is high. Since the spiro compounds are amorphous (irregular-shaped compounds that do not have a crystal structure), the spiro compounds tend to be densely filled in a porous electron transport layer. Since the spiro compounds do not absorb light of 450 nm or longer, furthermore, light absorption of the photosensitizing compound can be effectively performed and therefore the spiro compounds are particularly preferable for a solid dye-sensitized solar cell.

The hole-transporting layer may have a single layer structure formed of a single material, or a laminate structure including a plurality of compounds. In the case where the hole-transporting layer has a laminate structure, a polymer material is preferably used for a layer of the hole-transporting layer disposed near the second electrode. Use of the polymer material having excellent film formability is advantageous because a surface of the porous electron-transporting layer can be made smoother and photoelectric conversion properties can be improved. Since the polymer material does not easily permeate the porous electron-transporting layer, moreover, a surface of the porous electron-transporting layer is desirably covered and an effect of preventing short circuits at the time when an electrode is disposed may be obtained.

The polymer material used for the hole-transporting layer is not particularly limited. Hole-transporting polymer materials known in the art can be used as the polymer material.

Examples of the hole-transporting polymer material include polythiophene compounds, polyphenylene vinylene compounds, polyfluorene compounds, polyphenylene compounds, polyarylamine compounds, and polythiadiazole compounds.

Examples of the polythiophene compounds include poly(3-n-hexylthiophene), poly(3-n-octyloxythiophene), poly(9,9'-dioctyl-fluorene-co-bithiophene), poly(3,3‴-didodecyl-quarter thiophene), poly(3,6-dioctylthieno[3,2-b]thiophene), poly(2,5-bis(3-decylthiophen-2-yl)thieno[3,2-b]thiophene), poly(3,4-didecylthiophene-co-thieno[3,2-b]thiophene), poly(3,6-dioctylthieno[3,2-b]thiophene-co-thieno[3,2-b]thiophene), poly(3,6-dioctylthieno[3,2-b]thiophene-co-thiophene), and poly(3,6-dioctylthieno[3,2-b]thiophene-co-bithiophene).

Examples of the polyphenylene vinylene compounds include poly[2-methoxy-5-(2-ethylhexyloxy)-1,4-phenylenevinylene], poly[2-methoxy-5-(3,7-dimethyloctyloxy)-1,4-phenylenevinylene], and poly[(2-methoxy-5-(2-ethylhexyloxy)-1,4-phenylenevinylene)-co-(4,4-biphenylene-vi nylene)].

Examples of the polyfluorene compounds include poly(9,9'-didodecylfluorenyl-2,7-diyl), poly[(9,9-dioctyl-2,7-divinylenefluorene)-alt-co-(9,10-anthracene)], poly[(9,9-dioctyl-2,7-divinylenefluorene)-alt-co-(4,4'-biphenylene)], poly[(9,9-dioctyl-2,7-divinylenefluorene)-alt-co-(2-methoxy-5-(2-ethylhexyloxy)-1,4-phenylene)], and poly [(9,9-dioctyl-2,7-diyl)-co-(1,4-(2,5-dihexyloxy)benzene)]. Examples of the polyphenylene compounds include poly[2,5-dioctyloxy-1,4-phenylene], and poly [2,5-di(2-ethylhexyloxy-1,4-phenylene] Examples of the polyarylamine compounds include poly[(9,9-dioctylfluorenyl-2,7-diyl)-alt-co-(N,N-diphenyl)-N,N-di(p-hexylphenyl)-1, 4-diaminobenzene], poly[(9,9-dioctylfluorenyl-2,7-diyl)-alt-co-(N,N'-bis(4-octyloxyphenyl)benzidine-N,N' -(1,4-diphenylene)], poly[(N,N-bis(4-octyloxyphenyl)benzidine-N,N-(1,4-diphenylene)], poly[(N,N'-bis(4-(2-ethylhexyloxy)phenyl)benzidine-N,N'-(1,4-diphenylene)], poly[phenylimino-1,4-phenylenevinylene-2,5-dioctyloxy-1,4-phenylenevinylene-1,4-p henylene], poly[p-tolylimino-1,4-phenylenevinylene-2,5-di(2-ethylhexyloxy)-1,4-phenylenevinyl ene-1,4-phenylene], and poly[4-(2-ethylhexyloxy)phenylimino-1,4-biphenylene]. Examples of the polythiadiazole compounds include poly[(9,9-dioctylfluorenyl-2,7-diyl)-alt-co-(1,4-benzo(2,1',3)thiadiazole], and poly(3,4-didecylthiophene-co-(1,4-benzo(2,1,3)thiadiazole). Among the above-listed examples, polythiophene compounds and polyarylamine compounds are preferable in view of carrier mobility and ionization potential.

### «Alkali metal salt»

The alkali metal salt is not particularly limited and may be appropriately selected depending on the intended purpose. Since the hole-transporting layer includes the alkali metal salt, output of the photoelectric conversion element can be improved, and light irradiation resistance and resistance to storage at a high temperature can be improved.

Examples of the alkali metal salt include lithium salts, sodium salts, and potassium salts.

Examples of the lithium salts include lithium chloride, lithium bromide, lithium iodide, lithium perchlorate, lithium bis(trifluoromethanesulfonyl)diimide, lithium diisopropylimide, lithium acetate, lithium tetrafluoroborate, lithium pentafluorophosphate, lithium tetracyanoborate, lithium bis(trifluoromethanesulfonyl)imide, lithium hexafluoropropane-1,3-disulfonylimide, lithium N,N-hexafluoro-1,3-disulfonylimide, and lithium (fluorosulfonyl)(trifluoromethanesulfonyl)imide.

Examples of the sodium salts include sodium chloride, sodium bromide, sodium iodide, sodium perchlorate, sodium bis(trifluoromethanesulfonyl)diimide, sodium acetate, sodium tetrafluoroborate, sodium pentafluorophosphate, and sodium tetracyanoborate.

Examples of the potassium salts include potassium chloride, potassium bromide, potassium iodide, and potassium perchlorate.

Among the above-listed examples, the lithium salts are preferable, lithium bis(trifluoromethanesulfonyl)diimide, lithium diisopropylimide, and lithium N,N-hexafluoro-1,3-disulfonylimide are more preferable, and lithium (fluorosulfonyl)(trifluoromethanesulfonyl)imide is particularly preferable because durability and stability of output properties can be enhanced because of improvement of conductivity.

An amount of the alkali metal salt is preferably 5 mol% or greater but 50 mol% or less, and more preferably 20 mol% or greater but 35 mol% or less, relative to the hole-transporting material.

### «Hypervalent iodine compound»

The term "hypervalent iodine compound" means a compound including iodine that formally contains 9 or more valence electrons exceeding octet. In other words, the hypervalent iodine compound is a compound including an iodine atom that includes more than 8 electrons required for the octet rule and is in the hypervalent state. The valence electrons are also called atomic valence electrodes, and are electrons occupying the outer electron shell excluding the inner electrons in the electron configuration of the atom.

Since the hole-transporting layer includes the hypervalent iodine compound in the photoelectric conversion element, durability and stability of output can be improved.

The hypervalent iodine compound for use in the present disclosure is not particularly limited and may be appropriately selected depending on the intended purpose. The hypervalent iodine compound preferably includes a periodinane compound, or a diaryliodonium salt, or both.

The periodinane compound and the diaryliodonium salt are highly soluble to a halogen-based solvent, such as chlorobenzene, and have low crystallinity and acidity. Therefore, adding the periodinane compound or the diaryliodonium salt, or both to the hole-transporting layer can improve output of the photoelectric conversion element.

Open circuit voltage of the photoelectric conversion element can be improved by making acidity of the hole-transporting layer low. Therefore, a material used for the hole-transporting layer is preferably a material having low acidity. A method for lowering the acidity of the hole-transporting layer is, for example, to increase a ratio (amount) of a basic material in the hole-transporting layer to lower the acidity of the hole-transporting layer. In this case, however, a ratio of the hole-transporting compound in the hole-transporting layer is reduced. Therefore, series resistance is high and output with light of high illuminance is reduced when open circuit voltage is improved by increasing the ratio of the basic material in the hole-transporting layer. When the acidity of the hole-transporting layer is lowered, therefore, a material having high solubility to a halogen-based solvent (e.g., chlorobenzene) and having low crystallinity and acidity, such as a periodinane compound and a diaryliodonium salt, is preferably used based on the reasons described above.

### <<<Periodinane compound>>>

The periodinane compound is not particularly limited and may be appropriately selected depending on the intended purpose, as long as the periodinane compound is a compound including iodine having the valence of 3 or 5 (iodine bonded to 3 or 5 atoms). Examples thereof include a compound represented by General Formula (1) below. 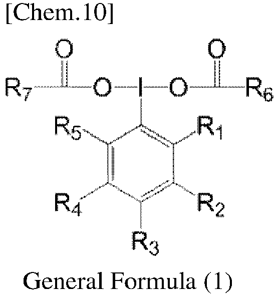 In General Formula (1), R₁ to R₅ are each a hydrogen atom, a methyl group, or a fluorine atom, and R₆ and R₇ are each a methyl group or a trifluoromethyl group.

The periodinane compound represented by General Formula (1) is not particularly limited and may be appropriately selected depending on the intended purpose. Examples of the periodinane compound represented by General Formula (1) include Exemplary Compounds (G-1) to (G-6) below, but the periodinane compound is not limited to these examples. The above-listed examples may be used alone or in combination.

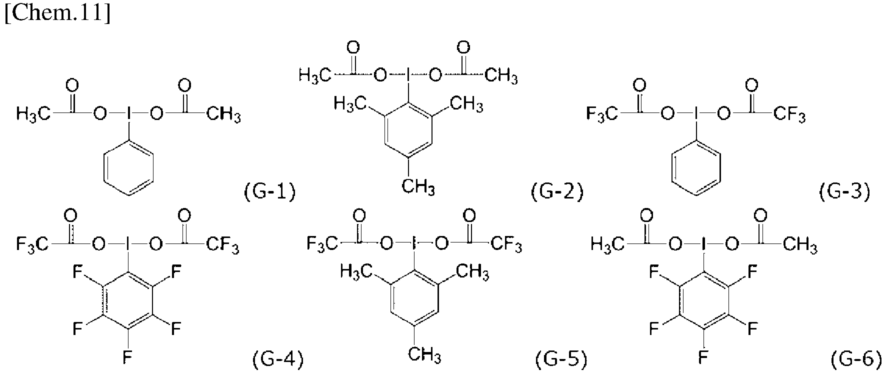

Moreover, the periodinane compound is not limited to a compound represented by General Formula (1) above. For example, the periodinane compound may be any of Exemplary Compounds (G-11) to (G-18) below.

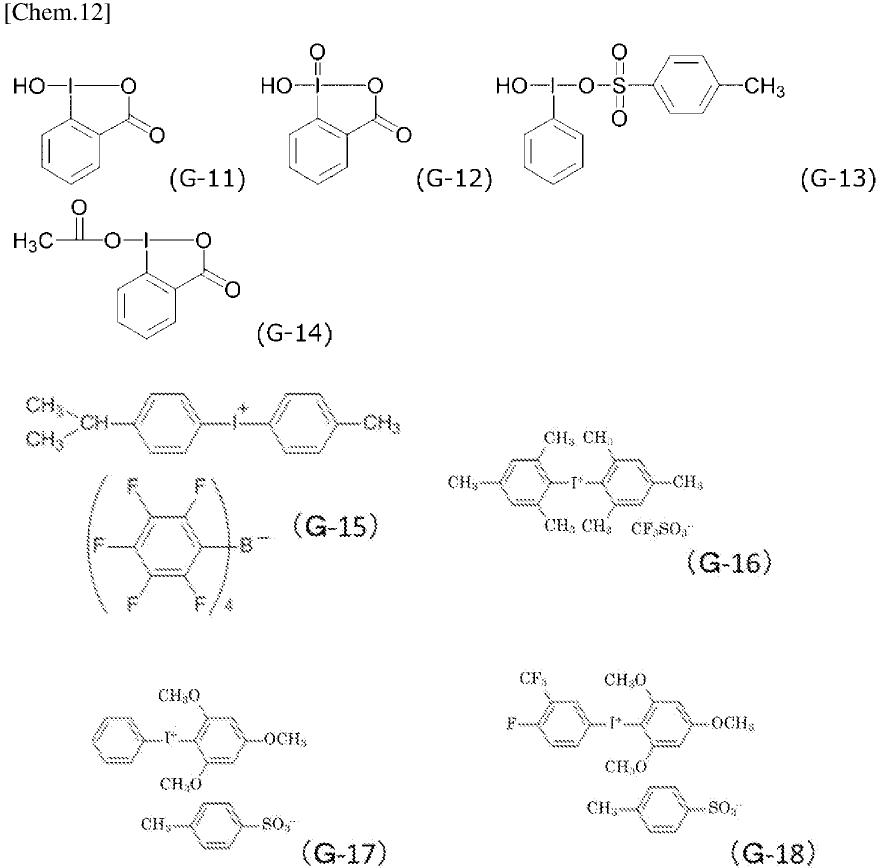

### <<<Diaryliodonium salt>>>

The diaryliodonium salt is not particularly limited and may be appropriately selected depending on the intended purpose, as long as the diaryliodonium salt is a compound represented by General Formula (2) or General Formula (9) below. 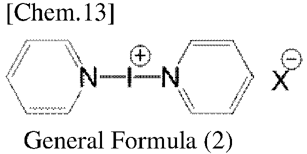 In General Formula (2), X is a compound represented by any one of Structural Formulae (1) to (4) below. 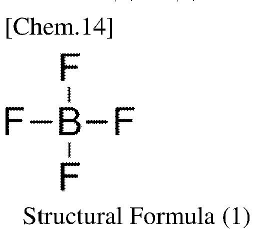 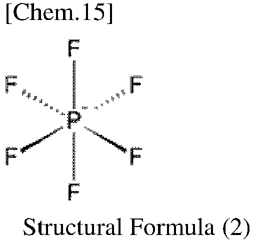 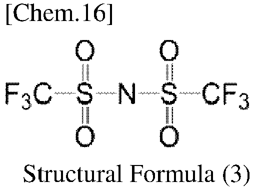 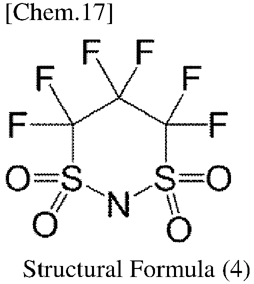 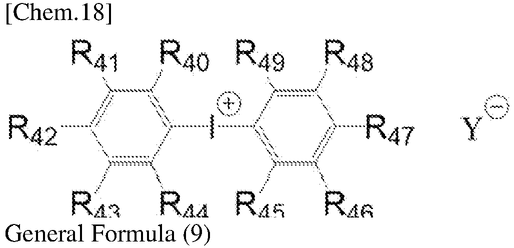 In General Formula (9) above, R₄₀ to R₄₈ are each a hydrogen atom, a fluorine atom, a methyl group, a trifluoromethyl group, a methoxy group, an isopropyl group, or a tertiary butyl group, and Y is a compound represented by any of Structural Formulae (8) to (10) below.

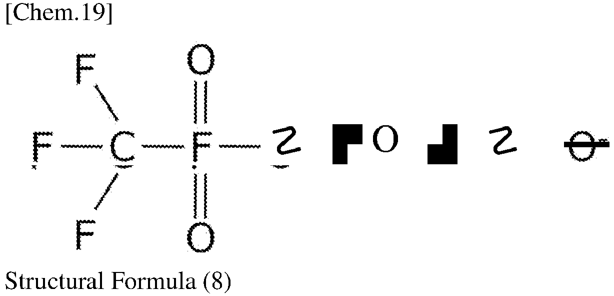

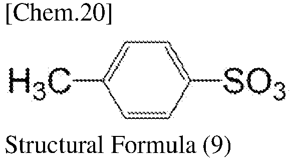

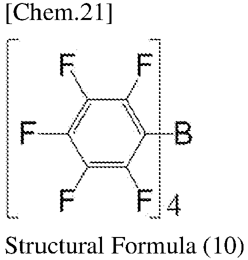

The diaryliodonium salt represented by General Formula (2) is not particularly limited and may be appropriately selected depending on the intended purpose. Examples of the diaryliodonium salt represented by General Formula (2) include Exemplary Compounds (G-7) to (G-10) below, but the diaryliodonium salt is not limited to these examples. The above-listed examples may be used alone or in combination.

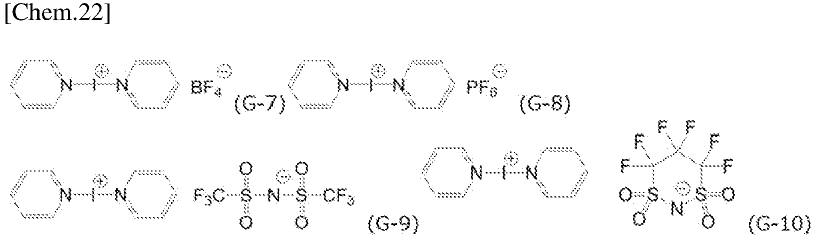

An amount of the hypervalent iodine compound is preferably 1 mol% or greater but 30 mol% or less, and more preferably 5 mol% or greater but 20 mol% or less, relative to the hole-transporting material.

Moreover, it is not necessary to oxidize the entire hole-transporting material with the function of the hypervalent iodine compound, as long as at least part of the hole-transporting material is oxidized.

### «Other components»

Other materials included in the hole-transporting layer are not particularly limited and may be appropriately selected depending on the intended purpose. Examples thereof include a basic compound, and other oxidizing agents.

### <<<Basic compound>>>

The hole-transporting layer preferably further includes a basic compound.

The basic compound included in the hole-transporting layer is not particularly limited and may be appropriately selected depending on the intended purpose. The hole-transporting layer preferably includes a basic compound represented by General Formula (3) below or a basic compound represented by General Formula (4) below, or both. Since the basic compound represented by General Formula (3) or the basic compound represented by General Formula (4), or both are included in the hole-transporting layer of the photoelectric conversion element, stability of output can be improved. Therefore, the photoelectric conversion element can more stably generate power with suppressing fluctuations of output properties with light of low illuminance.

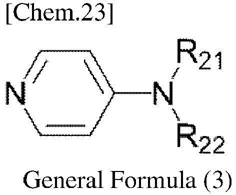

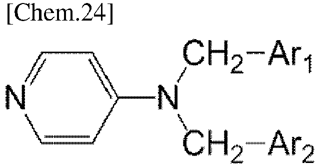

### General Formula (4)

In General Formula (3), R₂₁ and R₂₂ are each an alkyl group or an aromatic hydrocarbon group, or a nitrogen atom-including heterocyclic group formed by bonding R₂₁ and R₂₂ together. In General Formula (4), moreover, Ar₁ and Ar₂ are each an aryl group that may include a substituent.

The basic compound represented by General Formula (3) or General Formula (4) is not particularly limited and may be appropriately selected depending on the intended purpose. Examples of the basic compound represented by General Formula (3) or General Formula (4) include Exemplary Compounds (C-1) to (C-20) below, but the basic compound represented by General Formula (3) or General Formula (4) is not limited to these examples. The above-listed examples may be used alone or in combination.

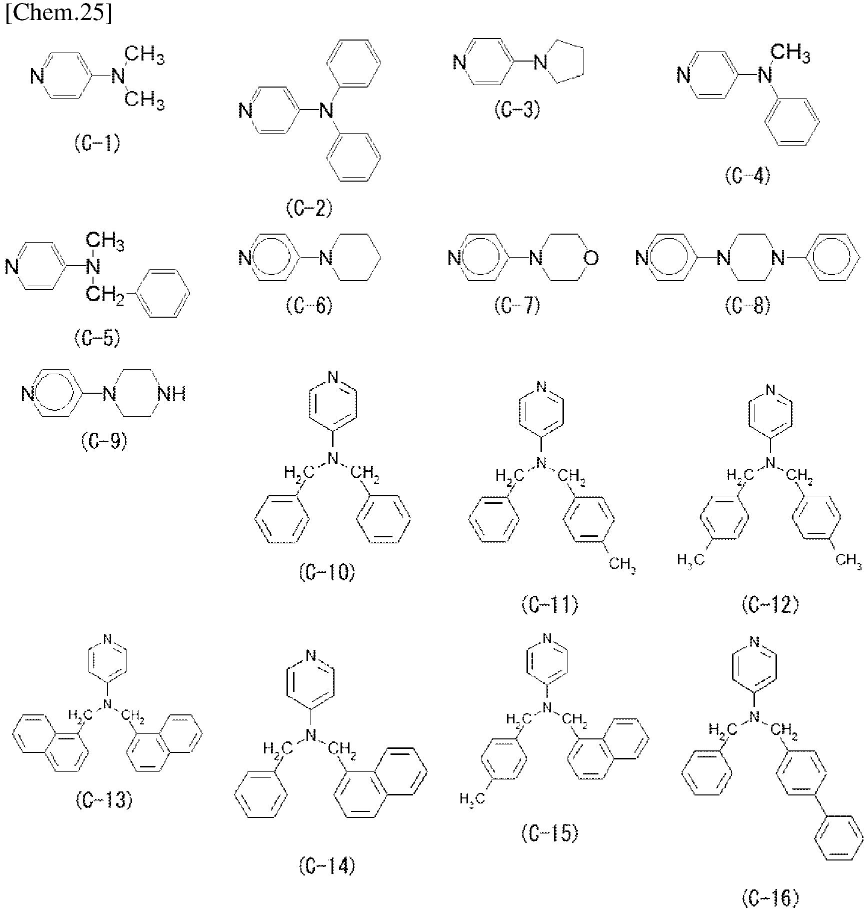

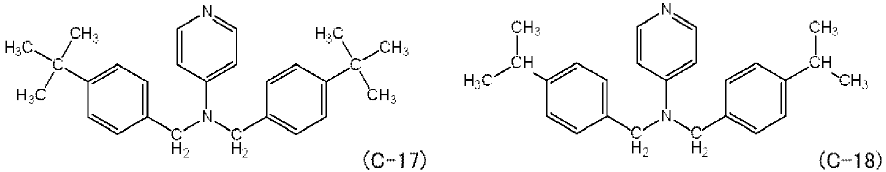

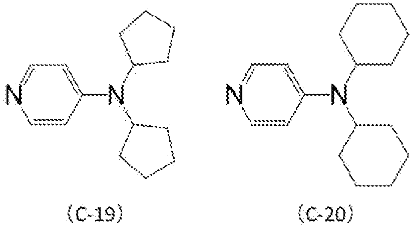

An amount of the basic compound represented by General Formula (3) or General Formula (4) in the hole-transporting layer is preferably 20 mol% or greater but 65 mol% or less, and more preferably 35 mol% or greater but 50 mol% or less, relative to the hole-transporting material. When the amount of the basic compound is within the above-mentioned preferable range, the photoelectric conversion element can maintain high open circuit voltage, can obtain high output, and can obtain high stability and durability even after use for a long period in various environments.

### <<<Other oxidizing agents>>>

The hole-transporting layer preferably further includes other oxidizing agents. Other oxidizing agents included in the hole-transporting layer are not particularly limited and may be appropriately selected depending on the intended purpose. Examples thereof include tris(4-bromophenyl)ammoniumyl hexachloroantimonate, silver hexafluoroantimonate, nitrosonium tetrafluoroborate, silver nitrate, and a metal complex. The above-listed examples may be used alone or in combination. Among the above-listed examples, a metal complex is preferable. Use of the metal complex as the oxidizing agent is advantageous because the metal complex has high solubility and residues are rarely remained. Note that, it is not necessary to oxidize the entire hole-transporting material using the hole-transporting material. It is effective of the hole-transporting material is partially oxidized. Moreover, the oxidizing agent may be taken out from the system or may be left in the system after the reaction.

Since the hole-transporting layer includes the oxidizing agent, part of or the entire hole-transporting material can be made radical cations, and therefore conductivity is improved, and durability and stability of the output properties can be enhanced.

The metal complex is not particularly limited and may be appropriately selected depending on the intended purpose. Examples thereof include a metal complex including at least a metal cation, a ligand, and an anion.

Examples of the metal cation include cations of chromium, manganese, iron, cobalt, nickel, copper, molybdenum, ruthenium, rhodium, palladium, silver, tungsten, rhenium, osmium, iridium, gold, and platinum. Among the above-listed examples, cations of iron, cobalt, nickel, and copper are preferable, and a cobalt complex is more preferable.

The cobalt complex is preferably a trivalent cobalt complex.

The ligand preferably includes a nitrogen-containing 5-membered heterocycle or a nitrogen-containing 6-membered heterocycle, or both, and may have a substituent. Specific examples thereof include Exemplary Compounds (E-1) to (E-33) below, but the ligand is not limited to these examples.

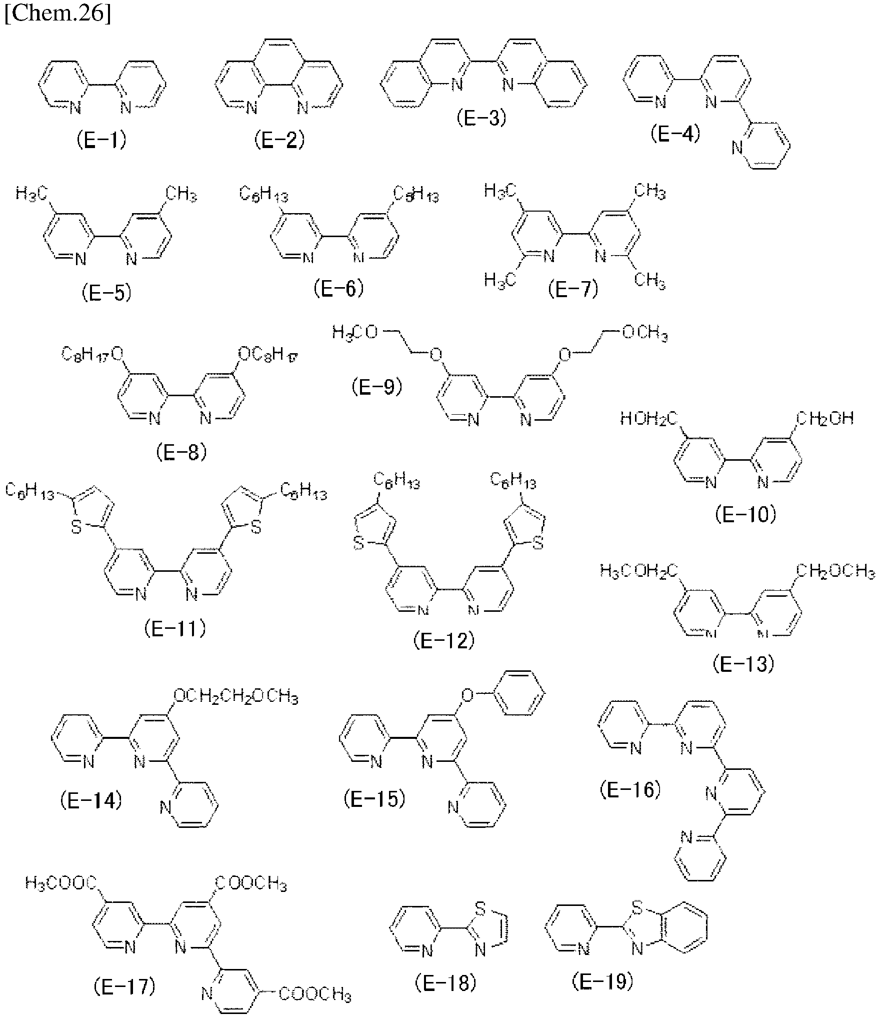

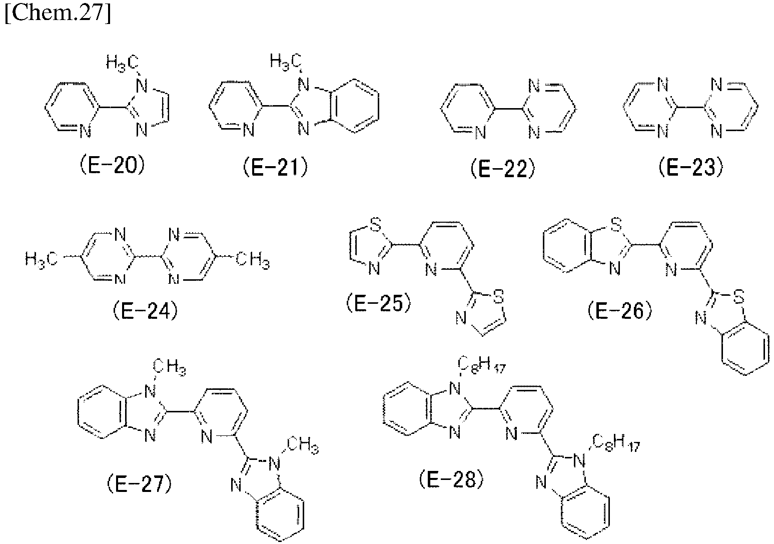

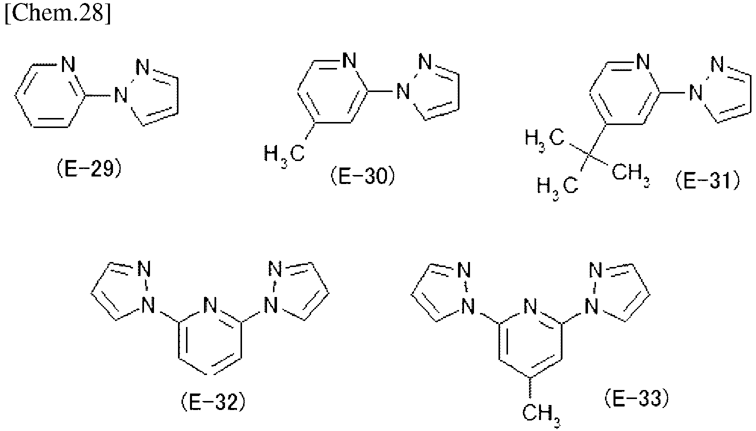

The anion is not particularly limited and may be appropriately selected depending on the intended purpose. Examples thereof include a hydride ion (H⁻), a fluoride ion (F⁻), a chloride ion (Cl⁻), a bromide ion (Br), an iodide ion (I⁻), a hydroxide ion (OH⁻), a cyanide ion (CN⁻), a nitric acid ion (NO₃⁻), a nitrous acid ion (NO₂⁻), a hypochlorous acid ion (ClO⁻), a chlorous acid ion (ClO₂⁻), a chloric acid ion (ClO₃⁻), a perchloric acid ion (ClO₄₋⁻), a permanganic acid ion (MnO₄⁻), an acetic acid ion (CH₃COO⁻), a hydrogen carbonate ion (HCO₃⁻), a dihydrogen phosphate ion (H₂PO₄⁻), a hydrogen sulfate ion (HSO₄⁻), a hydrogen sulfide ion (HS⁻), a thiocyanic acid ion (SCN⁻), a tetrafluoroboric acid ion (BF₄⁻), a hexafluorophosphate ion (PF₆⁻), a tetracyanoborate ion (B(CN)₄⁻), a dicyanoamine ion (N(CN)₂⁻), a p-toluenesulfonic acid ion (TsO⁻), a trifluoromethyl sulfonate ion (CF₃SO₂⁻), a bis(trifluoromethylsulfonyl)amine ion (N(SO₂ CF₃)²⁻), a tetrahydroxoaluminate ion ([Al(OH)₄]⁻ or [Al(OH)₄(H₂O)₂]⁻), a di-cyanoargentate (I) ion ([Ag(CN)₂]⁻), a tetrahydroxochromate (III) ion ([Cr(OH)₄]⁻), a tetrachloroaurate (III) ion ([AuCl₄]⁻), an oxide ion (O²⁻), a sulfide ion (S²⁻), a peroxide ion (O₂²⁻), a sulfuric acid ion (SO₄²⁻), a sulfurous acid ion (SO₃²⁻), a thiosulfuric acid (S₂ O₃²⁻), a carbonic acid ion (CO₃²⁻), a chromic acid ion (CrO₄²⁻), a dichromic acid ion (Cr₂ O₇²⁻), a monohydrogen phosphate ion (HPO₄²⁻), a tetrahydroxozincate (II) ion ([Zn(OH) ₄]²⁻), a tetracyanozincate (II) ion ([Zn(CN)₄]²⁻), a tetrachlorocuprate (II) ion ([CuCl₄]²⁻), a phosphoric acid ion (PO₄³⁻), a hexacyanoferrate (III) ion ([Fe(CN)₆]³⁻), a bis(thiosulfate)argentat (I) ion ([Ag(S₂O₃)₂]³⁻), and a hexacyanoferrate (II) ion ([Fe(CN) ₆]⁴⁻). The above-listed examples may be used alone or in combination.

Among the above-listed examples, a tetrafluoroboric acid ion, a hexafluorophosphate ion, a tetracyanoborate ion, a bis(trifluoromethylsulfonyl)amine ion, and a perchloric acid ion are preferable.

Moreover, the metal complex is particularly preferably a trivalent cobalt complex represented by General Formula (5) below. Use of the trivalent cobalt complex as the metal complex is advantageous because excellent functions of the oxidizing agent can be obtained.

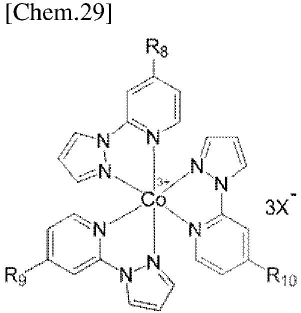

### General Formula (5)

In General Formula (5), R₈ to R₁₀ are each a methyl group, an ethyl group, a tertiary butyl group, or a trifluoromethyl group, and X is a compound represented by any one of Structural Formulae (1) to (4) above.

In General Formula (5), R₈ to R₁₀ are each preferably a methyl group, an ethyl group, a tertiary butyl group, or a trifluoromethyl group. Since R₈ to R₁₀ in General Formula (5) are each a methyl group, an ethyl group, a tertiary butyl group, or a trifluoro methyl group, a reduction in output with light of low illuminance after being exposed to light of high illuminance can be suppressed.

Specific examples of the cobalt complex represented by General Formula (5) include Exemplary Compounds (F-1) to (F-20) below, but the cobalt complex is not limited to these examples. The above-listed examples may be used alone or in combination.

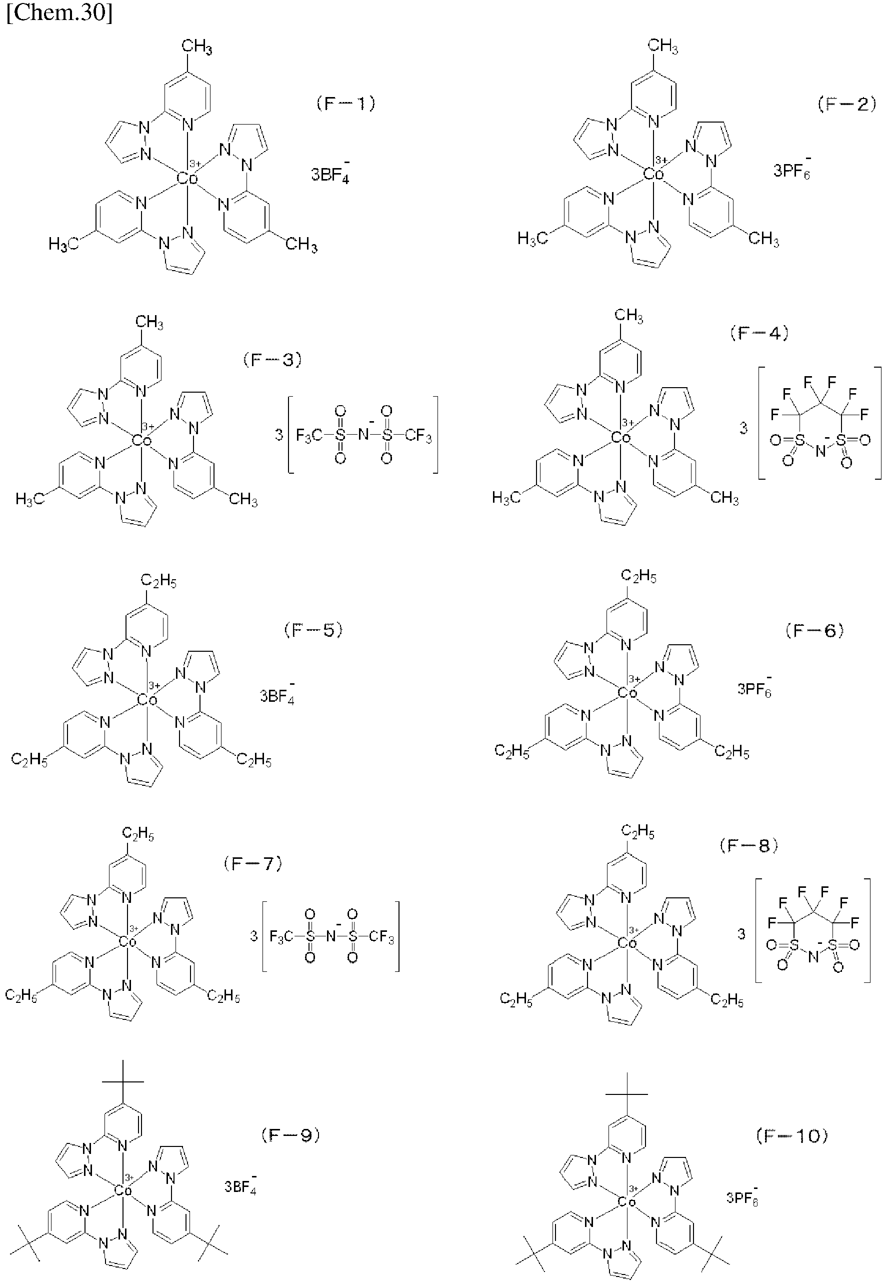

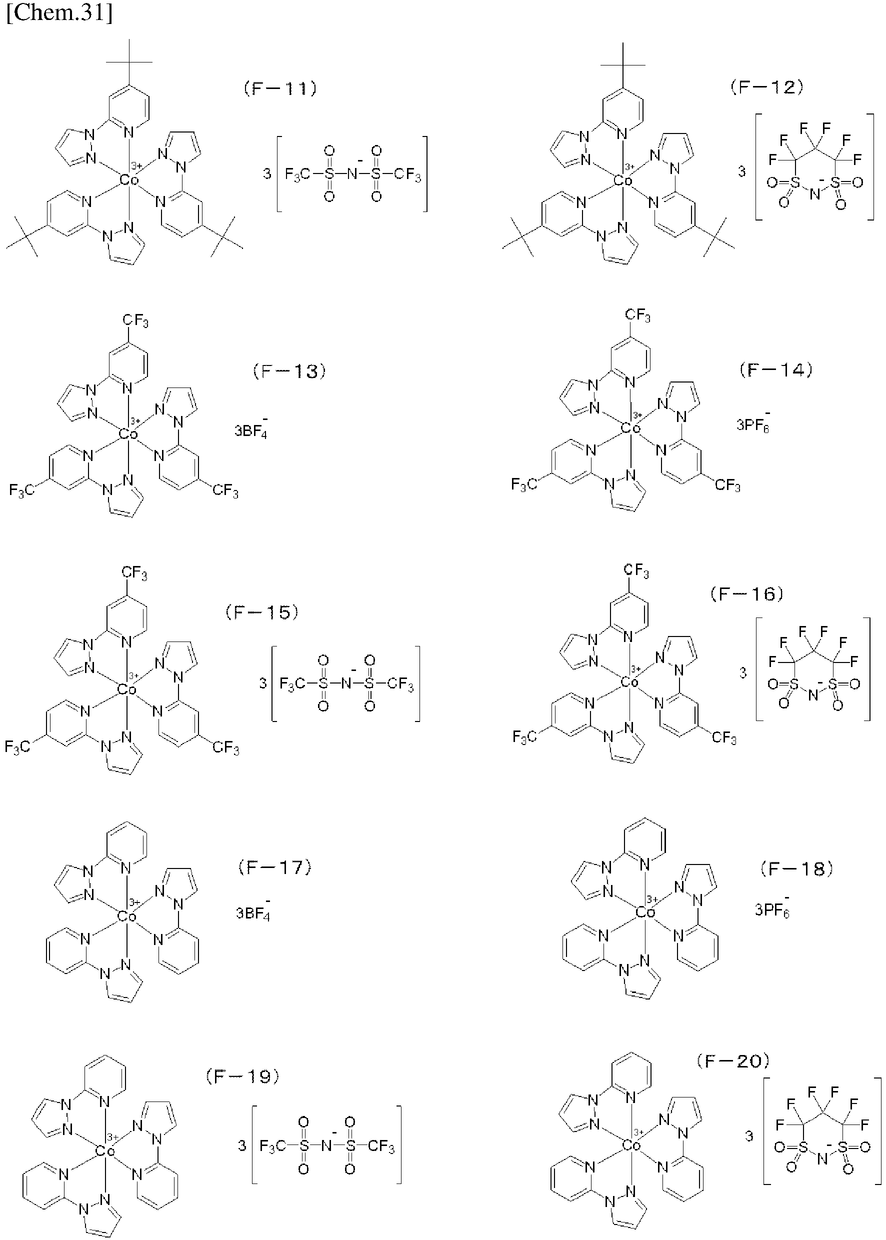

Moreover, a trivalent cobalt complex represented by General Formula (8) below is also effectively used as the metal complex.

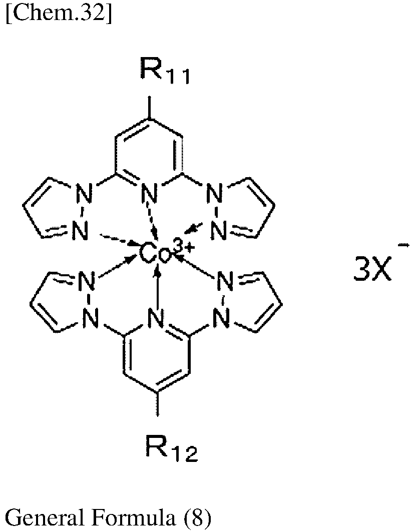

In General Formula (8), R₁₁ to R₁₂ are each a hydrogen atom, a methyl group, an ethyl group, a tertiary butyl group, or a trifluoromethyl group, and X is any of the above-listed anions.

Specific examples of the cobalt complex represented by General Formula (8) include Exemplary Compounds (F-21) to (F-24) below, but the cobalt complex is not limited to these examples. The above-listed examples may be used alone or in combination.

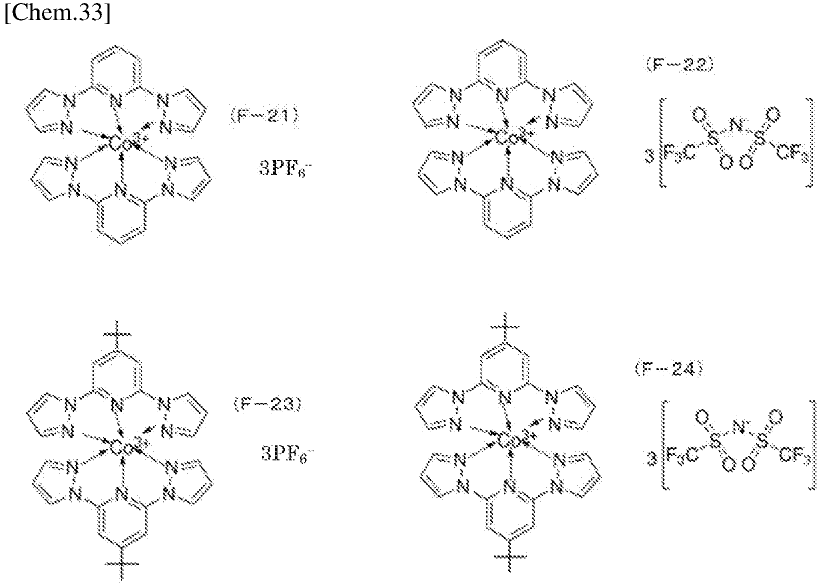

An amount of the above-mentioned other oxidizing agents is preferably 2 mol% or greater but 20 mol% or less, and more preferably 7 mol% or greater but 15 mol% or less, relative to the hole-transporting material.

Moreover, it is not necessary to oxidize the entire hole-transporting material through the function of the above-mentioned other oxidizing agents as long as at least part of the hole-transporting material is oxidized.

A shape and size of the hole-transporting layer are not particularly limited and may be appropriately selected depending on the intended purpose.

An average thickness of the hole-transporting layer is not particularly limited and may be appropriately selected depending on the intended purpose. On the electron-transporting layer, the average thickness of the hole-transporting layer is preferably 0.01 micrometers or greater but 20 micrometers or less, more preferably 0.1 micrometers or greater but 10 micrometers or less, and even more preferably 0.2 micrometers or greater but 2 micrometers or less.

The hole-transporting layer can be directly formed on the electron-transporting layer. A method for producing the hole-transporting layer is not particularly limited and may be appropriately selected depending on the intended purpose. Examples of the method include a method where a thin film is formed in vacuum through vacuum deposition and a wet film forming method. In particular, among them, a wet film forming method is preferable, a method by coating the hole-transporting layer on the electron-transporting layer is more preferable, in terms of production cost.

The wet film forming method is not particularly limited and may be appropriately selected depending on the intended purpose. Examples thereof include a dip method, a spraying method, a wire bar method, a spin coating method, a roller coating method, a blade coating method, and a gravure coating method. As the wet printing method, methods such as relief printing, offset printing, gravure printing, intaglio printing, rubber plate printing, and screen printing may be used.

Moreover, the hole-transporting layer may be produced, for example, by forming a film in a supercritical fluid or subcritical fluid having a lower temperature and pressure than a critical point.

The supercritical fluid means a fluid, which exists as a non-condensable high-density fluid in a temperature and pressure region exceeding the limit (critical point) at which a gas and a liquid can coexist and does not condense even when being compressed, and is a fluid in a state of being equal to or higher than the critical temperature and is equal to or higher than the critical pressure. The supercritical fluid is not particularly limited and may be appropriately selected depending on the intended purpose. The supercritical fluid is preferably a supercritical fluid having a low critical temperature.

The subcritical fluid is not particularly limited and may be appropriately selected depending on the intended purpose, so long as it is a fluid that exists as a high-pressure liquid in a temperature and pressure region near the critical point. The fluids as exemplified as the supercritical fluid can be suitably used as the subcritical fluid.

Examples of the supercritical fluid include carbon monoxide, carbon dioxide, ammonia, nitrogen, water, alcohol solvents, hydrocarbon solvents, halogen solvents, and ether solvents.

Examples of the alcohol solvent include methanol, ethanol, and n-butanol.

Examples of the hydrocarbon solvent include ethane, propane, 2,3-dimethylbutane, benzene, and toluene. Examples of the halogen solvent include methylene chloride and chlorotrifluoromethane.

Examples of the ether solvent include dimethyl ether.

The above-listed examples may be used alone or in combination.

Among the above-listed examples, carbon dioxide, which has a critical pressure of 7.3 MPa and a critical temperature of 31 degrees Celsius, is preferable because carbon dioxide easily generates a supercritical state, and it is incombustible and is easily handled.

A critical temperature and critical pressure of the supercritical fluid are not particularly limited and may be appropriately selected depending on the intended purpose. The critical temperature of the supercritical fluid is preferably -273 degrees Celsius or higher but 300 degrees Celsius or lower, and more preferably 0 degrees Celsius or higher but 200 degrees Celsius or lower.

In addition to the supercritical fluid and subcritical fluid, an organic solvent or an entrainer may be used in combination. Adjustment of solubility in the supercritical fluid can be easily performed by adding the organic solvent or the entrainer.

The organic solvent is not particularly limited and may be appropriately selected depending on the intended purpose. Examples of the organic solvent include ketone solvents, ester solvents, ether solvents, amide solvents, halogenated hydrocarbon solvents, and hydrocarbon solvents.

Examples of the ketone solvent include acetone, methyl ethyl ketone, and methyl isobutyl ketone.

Examples of the ester solvent include ethyl formate, ethyl acetate, and n-butyl acetate.

Examples of the ether solvent include diisopropyl ether, dimethoxy ethane, tetrahydrofuran, dioxolane, and dioxane.

Examples of the amide solvent include N,N-dimethylformamide, N,N-dimethylacetamide, and N-methyl-2-pyrrolidone.

Examples of the halogenated hydrocarbon solvent include dichloromethane, chloroform, bromoform, methyl iodide, dichloroethane, trichloroethane, trichloroethylene, chlorobenzene, o-dichlorobenzene, fluorobenzene, bromobenzene, iodobenzene, and 1-chloronaphthalene.

Examples of the hydrocarbon solvent include n-pentane, n-hexane, n-octane, 1,5-hexadiene, cyclohexane, methylcyclohexane, cyclohexadiene, benzene, toluene, o-xylene, m-xylene, p-xylene, ethylbenzene, and cumene.

The above-listed examples may be used alone or in combination.

After the hole-transporting material is laminated on the electron-transporting layer, a press processing step may be performed. By performing the press processing, the hole-transporting material is closely adhered to the electron-transporting layer, which may improve the power generation efficiency in some cases.

A method of the press processing is not particularly limited and may be appropriately selected depending on the intended purpose. Examples thereof include the press molding method using a plate, which is represented by the infrared spectroscopy (IR) tablet molding device and the roll press method using a roller.

A pressure at which the press processing is performed is preferably 10 kgf/cm² or more, more preferably 30 kgf/cm² or more.

The duration of the pressing is not particularly limited and may be appropriately selected depending on the intended purpose. The duration thereof is preferably 1 hour or shorter. Moreover, heat may be applied at the time of the pressing.

At the time of the pressing, a release agent may be disposed between a pressing machine and the electrode.

The release agent is not particularly limited and may be appropriately selected depending on the intended purpose. Examples thereof include fluoro resins, such as polyethylene tetrafluoride, polychloroethylene trifluoride, ethylene tetrafluoridepropylene hexafluoride copolymers, perfluoroalkoxy fluoride resins, polyvinylidene fluoride, ethylene-ethylene tetrafluoride copolymers, ethylene-chloroethylene trifluoride copolymers, and polyvinyl fluoride. The above-listed examples may be used alone or in combination.

After performing the pressing but before disposing a second electrode, a film including metal oxide may be disposed between the hole-transporting layer and the second electrode.

The metal oxide is not particularly limited and may be appropriately selected depending on the intended purpose. Examples of thereof include molybdenum oxide, tungsten oxide, vanadium oxide, and nickel oxide. The above-listed examples may be used alone or in combination. Among them, molybdenum oxide is preferable.

A method for disposing the film including metal oxide on the hole-transporting layer is not particularly limited and may be appropriately selected depending on the intended purpose. Examples of the method include a method where a thin film is formed in vacuum such as sputtering and vacuum vapor deposition, and a wet film forming method.

The wet film forming method in the case where the film including metal oxide is formed is preferably a method by preparing a paste in which powders or sol of the metal oxide is dispersed and coating it on the hole-transporting layer.

The wet film forming method is not particularly limited and may be appropriately selected depending on the intended purpose. Examples thereof include a dip method, a spraying method, a wire bar method, a spin coating method, a roller coating method, a blade coating method, and a gravure coating method. As the wet printing method, methods such as relief printing, offset printing, gravure printing, intaglio printing, rubber plate printing, and screen printing may be used.

An average thickness of the film including metal oxide is not particularly limited and may be appropriately selected depending on the intended purpose. However, the average thickness thereof is preferably 0.1 nm or greater but 50 nm or less, more preferably 1 nm or greater but 10 nm or less.

### «Second electrode»

The second electrode is preferably formed on the hole-transporting layer or a film of the metal oxide in the hole-transporting layer. The second electrode can use the same as the first electrode.

A shape, structure, and size of the second electrode are not particularly limited and may be appropriately selected depending on the intended purpose.

Examples of a material of the second electrode include metals, carbon compounds, conductive metal oxides, and conductive polymers.

Examples of the metal include platinum, gold, silver, copper, and aluminium.

Examples of the carbon compound include graphite, fullerene, carbon nanotube, and graphene.

Examples of the conductive metal oxide include ITO, FTO, and ATO.

Examples of the conductive polymer include polythiophene and polyaniline.

The above-listed examples may be used alone or in combination.

The second electrode can be appropriately formed on the hole-transporting layer through a method such as coating, laminating, deposition, CVD, or bonding, depending on a kind of the material to be used or a kind of the hole-transporting layer.

Within the photoelectric conversion element, at least one of the first electrode and the second electrode is preferably substantially transparent. When the photoelectric conversion element of the present disclosure is used, the first electrode is preferably transparent to allow entrance of incident light from a side of the first electrode. In this case, a material that reflects light is preferably used for the second electrode, and glass, plastic, and a metal thin film on which a metal or conductive oxide is deposited are preferably used. In addition, provision of an anti-reflection layer at a side of the electrode into which the incident light enters is an effective means.

### <First substrate>

A shape, structure, and size of the first substrate are not particularly limited and may be appropriately selected depending on the intended purpose.

The material of the first substrate is not particularly limited and may be appropriately selected depending on the intended purpose, as long as the material thereof is a material having transparency and insulation properties. Examples of the material thereof include glass, plastic films, and ceramics. Among the above-listed examples, a material having heat resistance against a firing temperature is preferable when firing is performed to form an electron-transporting layer as described later. Moreover, the first substrate is preferably a substrate having flexibility.

### <Second substrate>

The second substrate is disposed so as to face the first substrate, so that the first substrate and the second substrate sandwich the photoelectric conversion elements.

A shape, structure, and size of the second substrate is not particularly limited and may be appropriately selected depending on the intended purpose.

A material of the second substrate is not particularly limited and may be appropriately selected depending on the intended purpose. Examples thereof include glass, plastic films, and ceramics.

A convex-concave part may be formed at a connection part of the second substrate with a sealing member, which will be described hereinafter, in order to increase close adhesiveness.

A formation method of the convex-concave part is not particularly limited and may be appropriately selected depending on the intended purpose. Examples of the formation method include a sand blasting method, a water blasting method, a chemical etching method, a laser processing method, and a method using abrasive paper.

A method for increasing close adhesiveness between the second substrate and the sealing member may be, for example, a method by removing an organic matter on the surface of the second substrate, or a method for improving hydrophilicity of the second substrate. The method for removing an organic matter on the surface of the second substrate is not particularly limited and may be appropriately selected depending on the intended purpose. Examples of the method include UV ozone washing and an oxygen plasma treatment.

### <Sealing member>

The sealing member is disposed between the first substrate and the second substrate, and seals the photoelectric conversion elements.

A material of the sealing member is not particularly limited and may be appropriately selected depending on the intended purpose. Examples thereof include cured products of acrylic resins and cured products of epoxy resins.

As the cured product of the acrylic resin, any of materials known in the art can be used, so long as the cured product of the acrylic resin is a product obtained by curing a monomer or oligomer including an acryl group in a molecule thereof.

As the cured product of the epoxy resin, any of materials known in the art can be used, so long as the cured product of the epoxy resin is a product obtained by curing a monomer or oligomer including an epoxy group in a molecule thereof.

Examples of the epoxy resin include water-dispersing epoxy resins, non-solvent epoxy resins, solid epoxy resins, heat-curable epoxy resins, curing agent-mixed epoxy resins, and ultraviolet ray-curable epoxy resins. Among them, heat-curable epoxy resins and ultraviolet ray-curable epoxy resins are preferable, ultraviolet ray-curable epoxy resins are more preferable. Note that, heating may be performed even when an ultraviolet ray-curable epoxy resin is used, and heating is preferably performed even after curing through ultraviolet ray irradiation.

Examples of the epoxy resin include bisphenol A-based epoxy resins, bisphenol F-based epoxy resins, novolac-based epoxy resins, alicyclic epoxy resins, long-chain aliphatic epoxy resins, glycidyl amine-based epoxy resins, glycidyl ether-based epoxy resins, and glycidyl ester-based epoxy resins. The above-listed examples may be used alone or in combination.

Moreover, a curing agent or various additives are preferably mixed with the epoxy resin according to the necessity.

The curing agent is not particularly limited and may be appropriately selected depending on the intended purpose. The curing agents are classified into, for example, amine-based curing agents, acid anhydride-based curing agents, polyamide-based curing agents, and other curing agents.

Examples of the amine-based curing agent include: aliphatic polyamine such as diethylenetriamine and triethylenetetramine; and aromatic polyamine such as methphenylenediamine, diaminodiphenylmethane, and diaminodiphenylsulfone.

Examples of the acid anhydride-based curing agent include phthalic anhydride, tetrahydrophthalic anhydride, hexahydrophthalic anhydride, methyltetrahydrophthalic anhydride, methylnadic anhydride, pyromellitic anhydride, HET anhydride, and dodecenylsuccinic anhydride.

Examples of other curing agents include imidazoles and polymercaptan. The above-listed examples may be used alone or in combination.

The additive is not particularly limited and may be appropriately selected depending on the intended purpose. Examples thereof include fillers, gap agents, polymerization initiators, drying agents (moisture absorbents), curing accelerators, coupling agents, flexibilizers, colorants, flame retardant auxiliaries, antioxidants, and organic solvents. Among them, fillers, gap agents, curing accelerators, polymerization initiators, and drying agents (moisture absorbents) are preferable, fillers and polymerization initiators are more preferable.

Inclusion of the filler as the additive prevents entry of moisture or oxygen, and further can achieve effects such as reduction in volumetric shrinkage at the time of curing, reduction in an amount of outgas at the time of curing or heating, improvement of mechanical strength, and control of thermal conductivity or fluidity. Therefore, inclusion of the filler as the additive is effective in maintaining stable output under various environments.

In addition, not only entering moisture or oxygen, but also outgas generated at the time of curing or heating the sealing member may affect output properties or durability of a photoelectric conversion element. Especially, outgas generated at the time of heating greatly may affect output properties of the photoelectric conversion element stored in a high temperature environment.

Entry of moisture or oxygen can be prevented by adding filler, a gap agent, a drying agent, etc. into the sealing member, and therefore an amount of the sealing member to be used can be reduced to thereby obtain an effect of reducing outgas. Inclusion of the filler, the gap agent, or the drying agent in the sealing member is effective not only at the time of curing but also at the time when the photoelectric conversion element is stored under a high temperature environment.

The filler is not particularly limited and may be appropriately selected depending on the intended purpose. Examples thereof include inorganic fillers such as crystalline or amorphous silica, talc, alumina, aluminium nitride, silicon nitride, calcium silicate, and calcium carbonate. These may be used alone or in combination.

An average primary particle diameter of the filler is preferably 0.1 micrometers or greater but 10 micrometers or less, more preferably 1 micrometer or greater but 5 micrometers or less. When the average primary particle diameter of the filler falls within the above preferable range, an effect of preventing entry of moisture or oxygen can be sufficiently obtained, an appropriate viscosity is obtained, and close adhesiveness to a substrate or a defoaming property is improved. In addition, it is also effective in terms of control of a width of the sealing part or workability.

An amount of the filler is preferably 10 parts by mass or greater but 90 parts by mass or less, more preferably 20 parts by mass or greater but 70 parts by mass or less, relative to the entire sealing member (100 parts by mass). When the amount of the filler falls within the above preferable range, an effect of preventing entry of moisture or oxygen can be sufficiently obtained, an appropriate viscosity is obtained, and close adhesiveness and workability is good.

The gap agent is also called a gap controlling agent or a spacer agent. By including the gap agent as the additive, it is possible to control the gap of the sealing part. For example, when a sealing member is provided on a first substrate or a first electrode and a second substrate is provided thereon for sealing, a gap of the sealing part is matched with a size of the gap agent because the sealing member includes the gap agent. As a result, it is possible to easily control the gap of the sealing part.

The gap agent is not particularly limited and may be appropriately selected depending on the intended purpose, so long as it is particulate, has a uniform diameter, and has high solvent resistance and heat resistance. The gap agent is preferably a material which has high affinity to an epoxy resin and is in the form of sphere particles. Specific examples thereof include glass beads, silica fine particles, and organic resin fine particles. The above-listed examples may be used alone or in combination.

A particle diameter of the gap agent can be selected depending on a gap of the sealing part to be set. The particle diameter thereof is preferably 1 micrometer or greater but 100 micrometers or less, more preferably 5 micrometers or greater but 50 micrometers or less.

The polymerization initiator is not particularly limited and may be appropriately selected depending on the intended purpose, so long as polymerization is initiated through heat and light. Examples thereof include thermal polymerization initiators and photopolymerization initiators.

The thermal polymerization initiator is a compound that generates active species such as radicals and cations upon heating. Examples thereof include azo compounds such as 2,2'-azobisbutyronitrile (AIBN) and peroxides such as benzoyl peroxide (BPO). Examples of the thermal cationic polymerization initiator include benzenesulfonic acid ester and alkyl sulfonium salt.

Meanwhile, as the photopolymerization initiator, a photocationic polymerization initiator is preferably used in the case of the epoxy resin. When the photocationic polymerization initiator is mixed with the epoxy resin and light is emitted, the photocationic polymerization initiator is decomposed to generate an acid, and the acid induces polymerization of the epoxy resin. Then, curing reaction proceeds. The photocationic polymerization initiator has such effects that less volumetric shrinkage during curing is caused, oxygen inhibition does not occur, and storage stability is high.

Examples of the photocationic polymerization initiator include aromatic diazonium salts, aromatic iodonium salts, aromatic sulfonium salts, metallocene compounds, and silanol-aluminium complexes.

Moreover, a photoacid generator having a function of generating an acid upon irradiation of light can be also used as the polymerization initiator. The photoacid generator functions as an acid for initiating cationic polymerization. Examples of the photoacid generator include onium salts such as ionic sulfonium salt-based onium salts and ionic iodonium salt-based onium salts including a cation part and an ionic part. The above-listed examples may be used alone or in combination.

An amount of the polymerization initiator added may be different depending on a material to be used. The amount of the polymerization initiator is preferably 0.5 parts by mass or greater but 10 parts by mass or less, more preferably 1 part by mass or greater but 5 parts by mass or less, relative to the total amount of the sealing member (100 parts by mass). When the amount of the polymerization initiator added falls the aforementioned preferable range, curing appropriately proceeds, remaining uncured products can be decreased, and excessive outgassing can be prevented.

The drying agent is also called a moisture absorbent and is a material having a function of physically or chemically adsorbing or absorbing moisture. When the sealing member includes the drying agent, it is possible to further improve moisture resistance and to decrease influence of outgas.

The drying agent is not particularly limited and may be appropriately selected depending on the intended purpose, but is preferably a particulate material. Examples of thereof include inorganic water-absorbing materials such as calcium oxide, barium oxide, magnesium oxide, magnesium sulfate, sodium sulfate, calcium chloride, silica gel, molecular sieve, and zeolite. Among them, zeolite is preferable because zeolite absorbs a large amount of moisture. The above-listed examples may be used alone or in combination.

The curing accelerator is also called a curing catalyst and is a material that accelerates curing speed. The curing accelerator is mainly used for a heat curable epoxy resin.

The curing accelerator is not particularly limited and may be appropriately selected depending on the intended purpose. Examples thereof include: tertiary amine or tertiary amine salts such as DBU (1,8-diazabicyclo(5,4,0)-undecene-7) and DBN (1,5-diazabicyclo(4,3,0)-nonene-5); imidazole-based compounds such as 1-cyanoethyl-2-ethyl-4-methylimidazole and 2-ethyl-4-methylimidazole; and phosphine or phosphonium salts such as triphenylphosphine and tetraphenylphosphonium • tetraphenyl borate. The above-listed examples may be used alone or in combination.

The coupling agent is not particularly limited and may be appropriately selected depending on the intended purpose, so long as it is a material having an effect of increasing molecular binding force. Examples thereof include silane coupling agents. Specific examples thereof include: silane coupling agents, such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxy silane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, and 3-methacryloxypropyltrimethoxysilane. The above-listed examples may be used alone or in combination.

As the sealing member, epoxy resin compositions that are commercially available as sealing materials, seal materials, or adhesives have been known, and such commercially available products can be effectively used in the present disclosure. Among them, there are also epoxy resin compositions that are developed and are commercially available to be used in solar cells or organic EL elements, and such commercially available products can be particularly effectively used in the present disclosure. Examples of the commercially available epoxy resin compositions include: TB3118, TB3114, TB3124, and TB3125F (available from ThreeBond); World Rock 5910, World Rock 5920, and World Rock 8723 (available from Kyoritsu Chemical Co., Ltd.); and WB90US(P) (available from MORESCO Corporation).

In the present disclosure, a sealing sheet material may be used as the sealing material. The sealing sheet material is a material where an epoxy resin layer has been formed on a sheet in advance. In the sheet, glass or a film having high gas barrier properties is used. A sealing member and a second substrate can be formed at once by bonding the sealing sheet material onto the second substrate, followed by curing. A structure having a hollow part can be formed depending on a formation pattern of the epoxy resin layer formed on the sheet.

A method for forming the sealing member is not particularly limited and may be appropriately selected depending on the intended purpose. Examples thereof include a dispensing method, a wire bar method, a spin coating method, a roller coating method, a blade coating method, and a gravure coating method. Moreover, as a method for forming the sealing member, methods such as relief printing, offset printing, gravure printing, intaglio printing, rubber plate printing, and screen printing may be used.

Moreover, a passivation layer may be disposed between the sealing member and the second electrode. The passivation layer is not particularly limited and may be appropriately selected depending on the intended purpose, so long as the passivation layer is disposed in such a manner that the sealing member is not in contact with the second electrode. Examples thereof include aluminium oxide, silicon nitride, and silicon oxide.

### <Other members>

The above-mentioned other members are not particularly limited and may be appropriately selected depending on the intended purpose.

### (Solar cell module)

The solar cell module of the present disclosure includes a plurality of the photoelectric conversion elements of the present disclosure. Specifically, the solar cell module of the present disclosure includes a plurality of a photoelectric conversion elements each including a first electrode, an electron-transporting layer, a hole-transporting layer, and a second electrode, where the hole-transporting layer includes at least a hole-transporting material, an alkali metal salt, and a hypervalent iodine compound.

In the solar cell module, moreover, among at least two adjacent photoelectric conversion elements, at least the hole-transporting layer of the photoelectric conversion element and at least the hole-transporting layer of the adjacent photoelectric conversion element are preferably extended (linked) to each other. Since the hole-transporting layers in the two adjacent photoelectric conversion elements are extended to each other, short-circuit between a second electrode in the photoelectric conversion element and the first electrode in the adjacent photoelectric conversion element can be suppressed when the second electrode is disposed after forming the hole-transporting layer.

In the case where each photoelectric conversion element includes a hole-blocking layer in the solar cell module, among at least two adjacent photoelectric conversion elements, the hole-blocking layers are preferably not extended to each other (separated from each other). Since the hole-blocking layers are not extended to each other, occurrences of current leakage due to light of high illuminance can be suppressed.

In the case where each photoelectric conversion element includes a hole-blocking layer in the solar cell module, among at least two adjacent photoelectric conversion elements, it is preferred that the hole-transporting layers be extended to each other but the hole-blocking layers be not extended to each other. Specifically, the solar cell module more preferably has a configuration where a hole-blocking layer is included, the heat-transporting layers are extended to each other among the at least two adjacent photoelectric conversion elements, and the hole-blocking layers are not extended to each other among the at least two adjacent photoelectric conversion elements.

Since the solar cell module has the above-described configuration, occurrences of current leakage is prevented when the solar cell module is used as a self-sustaining power supply for a sensor etc., and high output can be obtained with light of low illuminance even when the solar cell module has been exposed to light of high illuminance. Since the gaps created by patterning can be sufficiently covered with the hole-blocking layer when the hole-blocking layer is formed after patterning the first electrode with laser light, the contact between the first electrode and the hole-transporting layer is prevented, and high output can be obtained with light of low illuminance. Since the hole-transporting layers are extended to each other and the hole-blocking layers are not extended to each other, specifically, a reduction in output with light of low illuminance can be suppressed even after exposed to light of high illuminance.

In addition, among at least two adjacent photoelectric conversion elements in the solar cell module, the first electrode of one photoelectric conversion element and the second electrode of the other photoelectric conversion element may be electrically connected via a conductive part penetrating the extended hole-transporting layer.

### (Power supply module)

The power supply module of the present disclosure includes the photoelectric conversion element and/or solar cell module of the present disclosure and a power supply circuit (power supply integrated circuit (IC)), and may further include other members according to the necessity. The above-mentioned other members included in the power supply module are not particularly limited and may be appropriately selected depending on the intended purpose. The details of the power supply module of the present disclosure will be described later.

### (Electronic device)

The electronic device of the present disclosure includes at least one selected from the group consisting of the photoelectric conversion element of the present disclosure, the solar cell module of the present disclosure, and the power supply module of the present disclosure, and a device configured to be driven by electricity generated by at least one selected from the group consisting of the photoelectric conversion element, the solar cell module, and the power supply module. The electronic device may further include other members according to the necessity. Other members included in the electronic device are not particularly limited and may be appropriately selected depending on the intended purpose. Details of the electronic device of the present disclosure will be described later.

Hereinafter, one embodiment for conducting the present disclosure will be described with reference to drawings. In each drawing, the same reference numeral is given to the same component, and redundant description may be omitted.

### <Structure of photoelectric conversion element>

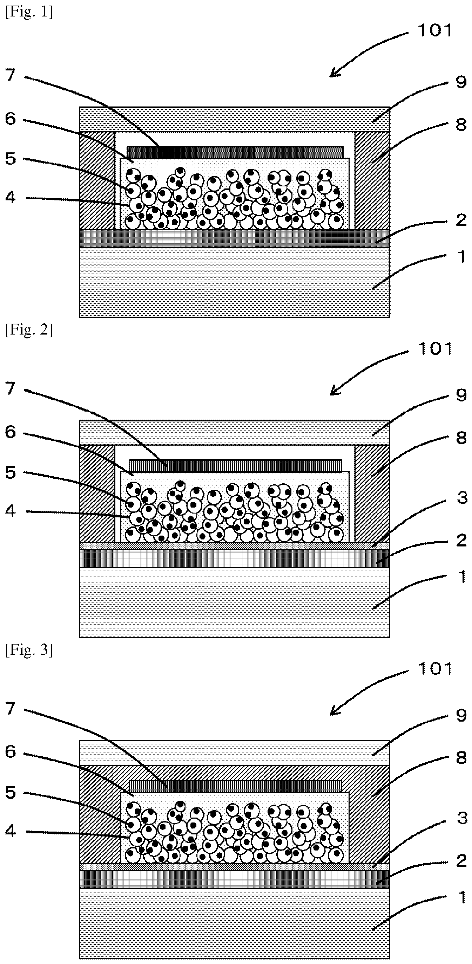

FIG. 1 is a schematic view illustrating one example of the photoelectric conversion element of the present disclosure. As illustrated in FIG. 1, the photoelectric conversion element 101 includes a first electrode 2 formed on a first substrate 1. An electron-transporting layer 4 is formed on the first electrode 2 and a photosensitizing compound 5 is adsorbed on a surface of an electron-transporting material constituting the electron-transporting layer 4. At the upper part and inner part of the electron-transporting layer 4, a hole-transporting layer 6 is formed. A second electrode 7 is formed on the hole-transporting layer 6. At the upper side of the second electrode 7, a second substrate 9 is disposed. The second substrate 9 is fixed with the first electrode 2 via a sealing member 8.

The photoelectric conversion element illustrated in FIG. 1 has a void part between the second electrode 7 and the second substrate 9. Since the void part is arranged, a moisture content or oxygen concentration inside the void part can be controlled and power generation capability or durability can be improved. Since the second electrode 7 and the second substrate 9 are not directly in contact with each other, moreover, peeling or breakage of the second electrode 7 can be prevented.

The oxygen concentration inside the void part is not particularly limited and may be freely selected. The oxygen concentration is preferably 0 percent or greater but 21 percent or less, more preferably 1 percent or greater but 15 percent or less, and even more preferably 5 percent or greater but 10 percent or less. Each of the first electrode 2 and the second electrode 7 has a path for conducting from each electrode to each electrode output terminal.

FIG. 2 is a schematic view illustrating another example of the photoelectric conversion element of the present disclosure. A hole-blocking layer 3 is formed between the first substrate 1 and the electron-transporting layer 4. The formation of the hole-blocking layer 3 can prevent recombination of electrons and holes and can improve power generation capability.

Similarly to FIG. 1, the photoelectric conversion element illustrated in FIG. 2 has a void part between the second electrode 7 and the second substrate 9.

FIG. 3 is a schematic view illustrating another example of the photoelectric conversion element of the present disclosure, and illustrates an example where a void part is not disposed and the void part of FIG. 2 is covered with the sealing member 8. For example, the photoelectric conversion element as illustrated in FIG. 3 can be formed by a method where the sealing member 8 is applied onto an entire surface of the second electrode 7 and the second substrate 9 is disposed thereon, or a method using the above-described sealing sheet material. In this case, a void part inside the sealing may be completely removed, or the void part may be partially left. By covering the substantially entire surface of the second electrode with the sealing member as described, peeling or breakage of the second substrate 9 can be reduced, and mechanical strength of the photoelectric conversion element can be enhanced.

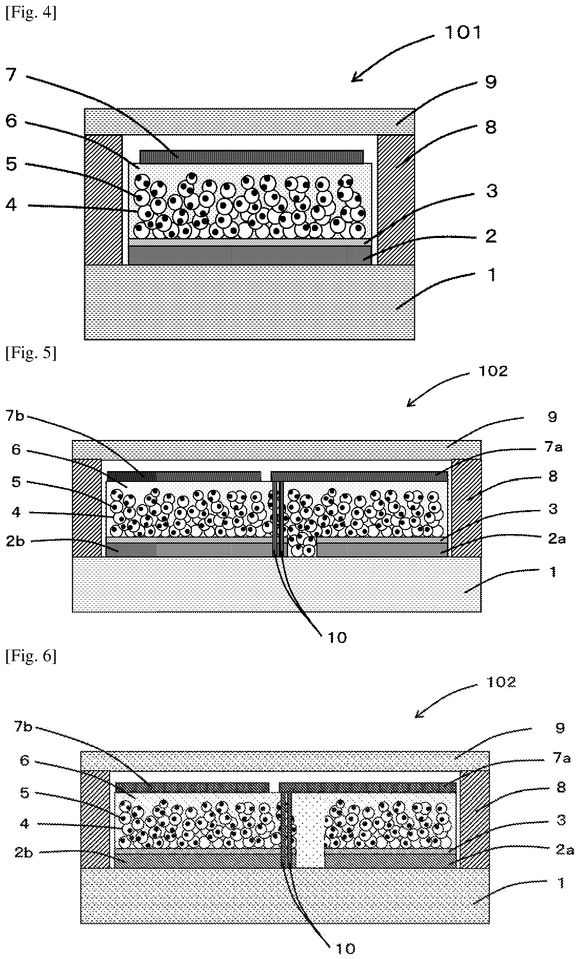

FIG. 4 is a schematic view illustrating another example of the photoelectric conversion element of the present disclosure and illustrates that the sealing member 8 is bonded to the first substrate 1 and the second substrate 9. Since the photoelectric conversion element has the above-described structure, adhesion of the sealing member 8 of the photoelectric conversion element is strong, and therefore an effect of enhancing mechanical strength of the photoelectric conversion element can be obtained. Since close bonding between the sealing member and the substrate is enhanced, moreover, an effect of enhancing a sealing effect for preventing entry of moisture or oxygen can be obtained.

### <Structure of solar cell module>

FIG. 5 is a schematic view illustrating one example of a solar cell module of the present disclosure and illustrates one example of the solar cell module where a plurality of photoelectric conversion elements are included and the photoelectric conversion elements are connected in series. In the solar cell module illustrated in FIG. 5, a through part 10 is formed after forming the hole-transporting layer 6, and then the second electrode 7 is formed to thereby introduce the second electrode material inside the through part 10 and conduct the first electrodes 2b of the adjacent cells. Note that, each of the first electrode 2a and the second electrode 7b has a path for conducting from each electrode to an electrode of the adjacent cell or an output terminal.

In FIG. 5, among at least two photoelectric conversion elements adjacent to each other in the solar cell module 102, the hole-transporting layers 6 are linked together without linking the hole-blocking layers 3 together. As a result, the solar cell module 102 hardly generates leak electric current with light of high illuminance and the photosensitizing compound is not easily damaged, and therefore a reduction in output with light of low illuminance even after being exposed to light of high illuminance can be suppressed. Therefore, the solar cell module 102 can has high power output with light emitted from illumination devices used indoors, such as LED and a fluorescent lamp even after being exposed to sun light.

Note that, the through part 10 may penetrate through the first electrode 2 to reach the first substrate 1. Alternatively, the through part 10 may not reach the first substrate 1 by stopping the processing inside the first electrode 2. In the case where a shape of the through part 10 is a fine pore that penetrates through the first electrode 2 to reach the first substrate 1, when a total opening area of the fine pore is too large relative to an area of the through part 10, a decreased cross-sectional area of the film of the first electrode 2 results in an increased resistance value, which may cause reduction in a photoelectric conversion efficiency. Therefore, a ratio of an opening area of the fine pore to an area of the through part 10 is preferably from 5/100 through 60/100.

Moreover, examples of a formation method of the through part 10 include sand blasting, water blasting, polishing with sand paper, chemical etching, and laser processing. In the present disclosure, laser processing is preferable. Performing laser processing realizes formation of fine pores without using sands, etching, or a resist, and therefore processing can be performed cleanly and with good reproducibility. Since the laser processing is performed, moreover, at least one of the hole-blocking layer 3, the electron-transporting layer 4, the hole-transporting layer 6, and the second electrode 7 can be removed by impact peeling when the through part 10 is formed. As a result, it is not necessary to dispose a mask at the time of laminating, and removal and formation of the fine through part 10 can be easily and simply performed at once.

FIG. 6 is a schematic view illustrating another example of the solar cell module of the present disclosure. Unlike FIG. 5, the electron-transporting layer 4 is cut out from the adjacent photoelectric conversion element and each photoelectric conversion element has an independent layer structure. As a result, electric current leakage is reduced by suppressing electron diffusion as the electron-transporting layers 4 are not extended to each other in the solar cell module 102 illustrated in FIG. 6, and therefore light resistance is improved.

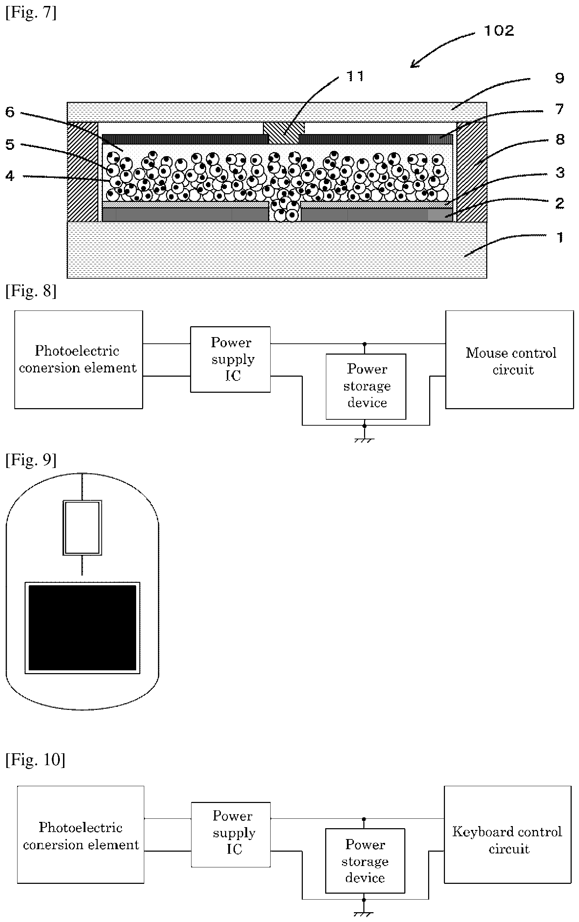

FIG. 7 is a schematic view illustrating another example of the solar cell module of the present disclosure and illustrates an example where the solar cell module includes a plurality of photoelectric conversion elements that are connected in series, and sealing members are disposed in a void part between the cell like beams. Peeling or breakage of the second substrate 9 can be prevented and mechanical strength of sealing can be enhanced by disposing sealing members like beams as illustrated in FIG. 7.

### <Embodiments of power supply module and electronic device>

FIG. 8 is a schematic block diagram illustrating a case where a mouse is used as an example of the electronic device of the present disclosure.

In the example illustrated in FIG. 8, the mouse, which is an example of the electronic device, includes a combination of the photoelectric conversion element, a power supply IC, and a power storage device, and electricity supplied thereby is transmitted to a mouse control circuit. In other words, the mouse illustrated in FIG. 8 includes the power supply module including the photoelectric conversion element and the power supply IC, the power storage device, and the mouse control circuit.

As a result, the power storage device is charged when the mouse is not used, and the mouse can be drive by the electricity stored in the power storage device. Therefore, it is not necessary to arrange wiring or replace a battery. Since a battery can be omitted, the mouse can be made light.

FIG. 9 is a schematic view illustrating an example of the mouse including the photoelectric conversion element.

In the example illustrated in FIG. 9, the photoelectric conversion element, the power supply IC, and the power storage device are mounted inside the mouse, but an upper part of the photoelectric conversion element is covered with a transparent housing to allow light to reach the photoelectric conversion element. Moreover, a whole housing of the mouse can be formed of a transparent material. The arrangement of the photoelectric conversion element is not limited to the example as mentioned above. For example, the photoelectric conversion element may be arranged at a position to which light is applied even when the mouse is covered with a hand, and such an arrangement may be preferable.

FIG. 10 is a schematic block diagram illustrating a case where a keyboard is used as an example of the electronic device of the present disclosure.

In the example illustrated in FIG. 10, the keyboard as an example of the electronic device includes a combination of the photoelectric conversion element, a power supply IC, and a power storage device, and electricity generated thereby is transmitted to a keyboard control circuit. In other words, the keyboard illustrated in FIG. 10 includes the power supply module including the photoelectric conversion element and the power supply IC, the power storage device, and the keyboard control circuit.

As a result, the power storage device is charged when the keyboard is not used, and the keyboard can be drive by the electricity stored in the power storage device. Therefore, it is not necessary to arrange wiring or replace a battery. Since a battery can be omitted, the keyboard can be made light.

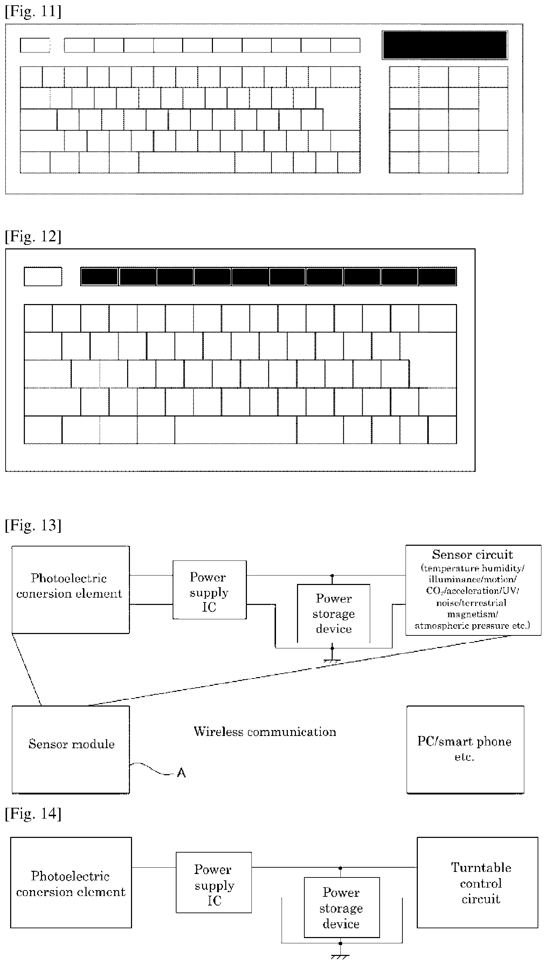

FIG. 11 is a schematic view illustrating an example of the keyboard including the photoelectric conversion element.

In the example illustrated in FIG. 11, the photoelectric conversion element, the power supply IC, and the power storage device are mounted inside the keyboard, but an upper part of the photoelectric conversion element is covered with a transparent housing to allow light to reach the photoelectric conversion element. Moreover, a whole housing of the mouse can be formed of a transparent material. The arrangement of the photoelectric conversion element is not limited to the example as mentioned above. In the case where a small keyboard having a space into which the photoelectric conversion element is disposed is small, for example, a small photoelectric conversion element may be embedded in part of the key as illustrated in FIG. 12, and such an arrangement may be effective.

FIG. 13 is a schematic block diagram illustrating a case where a sensor module is used as an example of the electronic device of the present disclosure.

In the example illustrated in FIG. 13, the sensor module, which is an example of the electronic device, includes a combination of the photoelectric conversion element, the power supply IC, and the power storage device, and electricity supplied thereby is transmitted to a sensor circuit. In other words, the sensor module illustrated in FIG. 13 includes the power supply module including the photoelectric conversion element and the power supply IC, the power storage device, and the sensor circuit. As a result of the configuration as described above, it is not necessary to connect the sensor module to an external power supply, and it is also not necessary to replace a battery.

Like the sensor module A of FIG. 13, moreover, the sensor module is configured to sense a measuring target on a periodic bases and transmit the read data to a personal computer (PC) or a smartphone through wireless communication.

Moreover, a sensing target of the sensor module is not particularly limited and may be appropriately selected depending on the intended purpose. Examples thereof include temperatures and humidity, illuminance, motion, carbon dioxide (CO₂), acceleration, UV, noise, terrestrial magnetism, and atmospheric pressure.

It is expected that use of sensors is getting significantly increased as the internet of things (IoT) society is realized. Replacing batteries of numeral sensors is time consuming and is not realistic. Moreover, the fact that a sensor is generally installed in a position where it is difficult to replace a battery, such as a celling and a wall, also makes workability bad. It is therefore a significant advantage for the sensor that electricity can be supplied by the photoelectric conversion element. Since the photoelectric conversion element of the present disclosure can obtain high output even with light of low illuminance, moreover, freedom in an arrangement of the sensor is high.

FIG. 14 is a schematic block diagram illustrating a case where a turntable is used as an example of the electronic device of the present disclosure.

In the example illustrated in FIG. 14, the turntable, which is an example of the electronic device, includes a combination of the photoelectric conversion element, the power supply IC, and the power storage device, and electricity supplied thereby is transmitted to a turntable circuit. In other words, the turntable illustrated in FIG. 14 includes the power supply module including the photoelectric conversion element and the power supply IC, the power storage device, and the turntable circuit. As a result of the configuration as described above, it is not necessary to connect the turntable to an external power supply, and it is also not necessary to replace a battery.

The turntable is used, for example, in a display case in which products are displayed. Wiring of a power supply of the turntable degrades an appearance of the display, and moreover displayed products need to be removed when a battery of the turntable is replaced, which is time-consuming work. The above-mentioned problems can be solved by using the photoelectric conversion element of the present disclosure in the turntable and therefore use thereof is effective.

### <Use>

The photoelectric conversion element and solar cell module of the present disclosure, the electronic device including a device that is driven by electricity generated by the photoelectric conversion element or solar cell module, and the power supply module are described above. However, use of the photoelectric conversion element and solar cell module of the present disclosure is not limited to the embodiments above.

The photoelectric conversion element and solar cell module of the present disclosure can function as a self-sustaining power supply, and a device can be driven by electricity generated through photoelectric conversion. Since the photoelectric conversion element and solar cell module can generate electricity upon irradiation of light, it is not necessary to connect the electronic device with a power supply or to replace a battery. Therefore, the electronic device can be driven in a place where there is no a power supply facility, the electronic device can be worn or used mobile, and the electronic device can be driven without replacing a battery in a place where it is difficult to perform replacement of the battery.

In the case where a dry cell is used, moreover, a weight of the electronic device increases by the weight of the dry cell or a size of the electronic device increases. Therefore, there may be a problem in installing the electronic device on a wall or celling, or transporting. Since the photoelectric conversion element and solar cell module of the present disclosure are light and thin, there is high freedom in installing, and there is a significant advantage in wearing or carrying the electronic device.

As described above, the photoelectric conversion element and solar cell module of the present disclosure can be used as self-sustaining power supply, and such a self-sustaining power supply can be combined with various electronic devices. For example, the photoelectric conversion element and solar cell module of the present disclosure can be used in combination with numerous electronic devices, such as a display device (e.g., an electronic desk calculator, a watch, a mobile phone, an electronic organizer, and electronic paper), an accessory device of a personal computer (e.g., a mouse and a keyboard), various sensor devices (e.g., a temperature and humidity sensor and a motion detection sensor), transmitters (e.g., a beacon and a global positioning system [GPS]), auxiliary lamps, and remote controllers.

The photoelectric conversion element and solar cell module of the present disclosure is widely applied because the photoelectric conversion element and solar cell module can generate electricity particularly with light of low illuminance and can generate electricity indoor, moreover in a shaded place. Moreover, the photoelectric conversion element and solar cell module are highly safe because liquid leakage is not cause unlike a dry cell, and accidental ingestion that is often caused with a button cell does not occur.

Moreover, the photoelectric conversion element and solar cell module of the present disclosure can be used as an auxiliary power supply for extending continuous usage time of a charge-type or dry cell-type of an electrical appliance. As described above, the photoelectric conversion element of solar cell module of the present disclosure can be effectively used for production of an electronic device that is light and easy to use, has high freedom in installing, does not require replacement of a battery, is highly safe, and is effective for reducing environmental loads by combining the photoelectric conversion element or solar cell module with a device driven by electricity generated through photoelectric conversion.

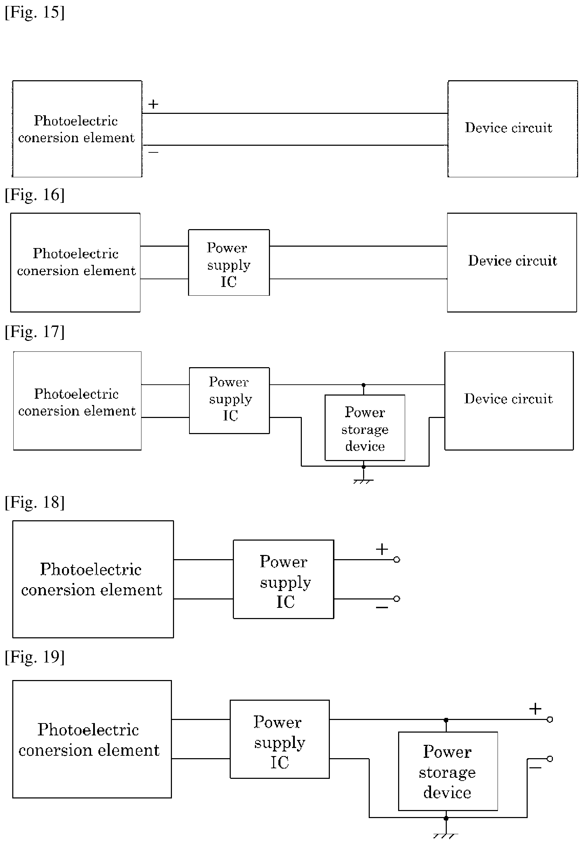

FIG. 15 is a schematic block view illustrating an example of the electronic device where the photoelectric conversion element and/or solar cell module is combined with a device driven by electricity (electric power) generated through photoelectric conversion performed by the photoelectric conversion element and/or solar cell module. The electronic device illustrated in FIG. 15 can generate electricity as the photoelectric conversion element is irradiated with light, and the electronic device can be driven by the drawn electricity.

Since output of the photoelectric conversion element varies depending on illuminance of the surrounding environment, moreover, a power supply IC is preferably disposed between photoelectric conversion element and the device circuit for the purpose of supplying stable voltage to the device circuit, as illustrated in FIG. 16. Specifically, the electronic device of the present disclosure preferably includes the power supply module of the present disclosure.

By incorporating a power storage device, such as a capacitor, between the power supply IC and the device circuit, as illustrated in FIG. 17, the excess electricity from the photoelectric conversion element can be stored in the power storage device. As a result, the electricity stored in the power storage device can be supplied to the device circuit when illuminance is too low, or light is not applied to the photoelectric conversion element. Therefore, the electronic device can be stably driven.

As described above, the electronic device in which the photoelectric conversion element and/or solar cell module of the present disclosure and a device circuit (device) are combined can be driven even in an environment where a power supply is unavailable, does not require replacement of a battery, and can be stably driven by combining with a power supply IC or an energy storage device.

Meanwhile, the photoelectric conversion element and/or solar cell module of the present disclosure can be also used as a power supply module, and such use is effective. As illustrated in FIG. 18, for example, a DC power supply module capable of supplying electricity generated through photoelectric conversion performed by the photoelectric conversion element to a power supply IC for a photoelectric conversion element at a constant voltage level by connecting the photoelectric conversion element and/or solar cell module of the present disclosure to the power supply IC for the photoelectric conversion element.

Since the power supply module further includes the power storage device, as illustrated in FIG. 19, moreover, the electricity generated by the photoelectric conversion element can be stored in the power storage device. As a result, the electricity can be supplied to the power supply module even when illuminance is too low or light is not applied to the photoelectric conversion element.

The power supply modules of the present disclosure illustrated in FIG. 18 and FIG. 19 can be used as a power supply module without replacing a battery as in case of primary cells known in the art.

### Examples

The present disclosure will be described in more detail by way of Examples and Comparative Examples. The present disclosure should not be construed as being limited to these Examples.

### (Example 1)

### <Production of photoelectric conversion element>

On a glass substrate serving as a first substrate, a film of a film of indium-doped tin oxide (ITO) and a film of niobium-doped tin oxide (NTO) were sequentially formed by sputtering. Subsequently, a dense layer (thickness: 20 nm) formed of titanium oxide serving as a hole-blocking layer was formed by reactive sputtering with oxygen gas.

Next, 3 g of titanium oxide (ST-21, available from ISHIHARA SANGYO KAISHA, LTD.), 0.2 g of acetyl acetate, 0.3 g of a surfactant (polyoxyethylene octylphenyl ether, available from Wako Pure Chemical Industries, Ltd.) were subjected to a bead mill treatment together with 5.5 g of water, and 1.0 g of ethanol for 12 hours, to thereby obtain a titanium oxide dispersion liquid. To the obtained titanium oxide dispersion liquid, 1.2 g of polyethylene glycol (#20,000, available from Wako Pure Chemical Industries, Ltd.) to produce a paste. The obtained paste is applied onto the hole-blocking layer in a manner that the average thickness of the applied paste was to be about 1.5 micrometers. After drying the paste at 60 degrees Celsius, the dried paste was fired in the air for 30 minutes at 550 degrees Celsius, to thereby form a porous electron-transporting layer.

The glass substrate on which the electron-transporting layer had been formed was immersed in a solution prepared by mixing and stirring 120 mg of the photosensitizing compound (dye) represented by B-5, 150 mg of chenodeoxycholic acid (available from Tokyo Chemical Industry Co., Ltd.), and a mixed liquid of acetonitrile/t-butanol (volume ratio: 1:1), and the glass substrate was left to stand in the above-described state in the dark for 1 hour, to thereby make the photosensitizing compound adsorbed on the surface of the electron-transporting layer.

Next, to 1 mL of a chlorobenzene solution, 150 mM of a hole-transporting material represented by D-7 (available from Merck), 60 mM of lithium bis(trifluoromethanesulfonyl)imide (available from KANTO CHEMICAL CO., INC.) serving as an alkali metal salt, 130 mM of the basic compound represented by C-1, and 20 mM of the hypervalent iodine compound represented by G-1 (available from Sigma-Aldrich Co., LLC.) were added and dissolved, to thereby prepare a hole-transporting layer coating liquid.

Next, the hole-transporting layer coating liquid was applied onto the electron-transporting layer onto which the photosensitizing compound had been adsorbed by spin coating, to thereby form a hole-transporting layer having a thickness of about 500 nm. Thereafter, an edge of the glass substrate at which a sealing member was to be disposed was etched by laser processing, and a through hole that was to be a drawing terminal part and to be connected to the ITO layer was formed by laser processing. Moreover, silver was deposited thereon by vacuum vapor deposition to thereby form a second electrode having a thickness of about 100 nm.

An ultraviolet ray-curable resin (TB3118, available from ThreeBond Holdings Co., Ltd.) was applied onto the edge of the glass substrate to surround the power generation region by means of a dispenser (2300N, available from SAN-EI TECH Ltd.). Thereafter, the resultant was transferred into a glove box in which a dew point was controlled to minus 40 degrees Celsius and an oxygen concentration was controlled to 2.5%, and cover glass serving as a second substrate was placed on the ultraviolet-ray curable resin, and the ultraviolet-ray curable resin was cured by UV irradiation to seal the power generation region, to thereby produce the photoelectric conversion element 1 illustrated in FIG. 1.

### <Evaluation of photoelectric conversion element>

IV properties of the obtained photoelectric conversion element 1 was evaluated under irradiation of white LED adjusted to 2,000 lux by means of a solar cell evaluation system (As-510-PV03, available from NF Corporation), to thereby determine initial open circuit voltage Voc1 (V) and the maximum output power Pmax1 (microwatt/cm² ). IV properties at 200 lux were evaluated in the similar manner to determine Voc2 and Pmax2. Subsequently, the photoelectric conversion element 1 was irradiated for 300 hours by means of a solar simulator (AM1.5, 10 mW/cm², 110,000 lux), and then IV properties at 2,000 lux and at 200 lux were again evaluated to measure the open circuit voltage and the maximum output power after the irradiation with light of high illuminance. Then, a retention rate of the open circuit voltage and a retention rate of the maximum output power were determined. The results are presented in Table 2.

### (Examples 2 to 12)

Photoelectric conversion elements 2 to 12 were produced in Examples 2 to 12, respectively, in the same manner as in Example 1, except that the dye, the hole-transporting material, the alkali metal salt, the basic material, and the hypervalent iodine compound used in Example 1 were changed to the materials presented in Table 1. Then, Voc1, Pmax1, Voc2, Pmax2, and retention rates of each of the obtained photoelectric conversion elements 2 to 12 were determined in the same manner as in Example 1. The results are presented in Table 2.

### (Examples 13 to 16)

Photoelectric conversion elements 13 to 16 were produced in Examples 13 to 16, respectively, in the same manner as in Example 9, except that 10 mM of a trivalent cobalt complex F-11 presented in Table 1 was added to the hole-transporting layer of Example 9. Then, Voc1, Pmax1, Voc2, Pmax2, and retention rates of each of the obtained photoelectric conversion elements 13 to 16 were determined in the same manner as in Example 1. The results are presented in Table 2.

### (Example 17)

A photoelectric conversion element 17 was produced in the same manner as in Example 16, except that the alkali metal salt was changed to lithium (fluorosulfonyl)(trifluoromethanesulfonyl)imide. Then, Voc1, Pmax1, Voc2, Pmax2, and the retention rate of the obtained photoelectric conversion element 17 were determined in the same manner as in Example 1. The structure of the photoelectric conversion element is presented in Table 1. The results are presented in Table 2.

### (Example 18)

A photoelectric conversion element 18 was produced in the same manner as in Example 4, except that the alkali metal salt was changed to lithium (fluorosulfonyl)(trifluoromethanesulfonyl)imide. Then, Voc1, Pmax1, Voc2, Pmax2, and the retention rate of the obtained photoelectric conversion element 18 were determined in the same manner as in Example 1. The structure of the photoelectric conversion element is presented in Table 1. The results are presented in Table 2.

### (Example 19)

A photoelectric conversion element 19 was produced in the same manner as in Example 17, except that the hypervalent iodine compound was changed to G-15. Then, Voc1, Pmax1, Voc2, Pmax2, and the retention rate of the obtained photoelectric conversion element 19 were determined in the same manner as in Example 1. The structure of the photoelectric conversion element is presented in Table 1. The results are presented in Table 2.

### (Comparative Example 1)

A photoelectric conversion element 17 was produced in Comparative Example 1 in the same manner as in Example 13, except that the hypervalent iodine compound was not included. Then, Voc1, Pmax1, Voc2, Pmax2, and retention rates of the obtained photoelectric conversion element 17 were determined in the same manner as in Example 1. The results are presented in Table 2.

### (Comparative Example 2)

A photoelectric conversion element 18 was produced in Comparative Example 2 in the same manner as in Example 3, except that the hypervalent iodine compound was not included and replaced with silver nitrate. Then, Voc1, Pmax1, Voc2, Pmax2, and retention rates of the obtained photoelectric conversion element 18 were determined in the same manner as in Example 1. The results are presented in Table 2.

### (Comparative Example 3)

A photoelectric conversion element 19 was produced in Comparative Example 3 in the same manner as in Example 3, except that the alkali metal salt was replaced with silver bis(trifluoromethanesulfonyl)imide. Then, Voc1, Pmax1, Voc2, Pmax2, and retention rates of the obtained photoelectric conversion element 19 were determined in the same manner as in Example 1. The results are presented in Table 2.

### (Comparative Example 4)

A photoelectric conversion element 20 was produced in Comparative Example 4 in the same manner as in Example 3, except that the hypervalent iodine compound was not included. Then, Voc1, Pmax1, Voc2, Pmax2, and retention rates of the obtained photoelectric conversion element 20 were determined in the same manner as in Example 1. The results are presented in Table 2.

### (Comparative Example 5)

A photoelectric conversion element 21 was produced in Comparative Example 5 in the same manner as in Example 3, except that the alkali metal salt was not included. Then, Voc1, Pmax1, Voc2, Pmax2, and retention rates of the obtained photoelectric conversion element 21 were determined in the same manner as in Example 1. The results are presented in Table 2.

In Table 1, the numbers presented in the columns of the dye, the hole-transporting material, the basic material, the hypervalent iodine compound, and the cobalt complex are the numbers of Exemplary Compound listed in the present specification.

In the column of the alkali metal salt of Table 1, Li-TFSI is lithium bis(trifluoromethanesulfonyl)imide, Li-HFSI is lithium hexafluoropropane-1,3-disulfonylimide, Ag-TFSI is silver bis(trifluoromethanesulfonyl)imide, and Li-FTFSI is lithium (fluorosulfonyl)(trifluoromethanesulfonyl)imide.

The manufacturer of each Exemplary Compound in Table 1 is as follows.

G-3: available from Tokyo Chemical Industry Co., Ltd.

G-4: available from Tokyo Chemical Industry Co., Ltd.

G-7: available from Tokyo Chemical Industry Co., Ltd.

G-11: available from Tokyo Chemical Industry Co., Ltd.

G-13: available from Tokyo Chemical Industry Co., Ltd.

G-15: available from Tokyo Chemical Industry Co., Ltd.

**[Table 1]**

| No. | Dye | Hole-transporting material | Alkaline metal salt | Basic material | Hypervalent iodine compound | Cobalt complex |
|---|---|---|---|---|---|---|
| Ex. 1 | B-5 | D-7 | Li-TFSI | C-1 | G-1 | - |
| Ex. 2 | B-5 | D-7 | Li-TFSI | C-3 | G-1 | - |
| Ex. 3 | B-5 | D-7 | Li-TFSI | C-10 | G-1 | - |
| Ex. 4 | B-5 | D-7 | Li-TFSI | C-10 | G-3 | - |
| Ex. 5 | B-5 | D-7 | Li-TFSI | C-10 | G-4 | - |
| Ex. 6 | B-5 | D-7 | Li-TFSI | C-10 | G-7 | - |
| Ex. 7 | B-5 | D-7 | Li-TFSI | C-10 | G-11 | - |
| Ex. 8 | B-5 | D-7 | Li-TFSI | C-10 | G-13 | - |
| Ex. 9 | B-5 | D-7 | Li-HFSI | C-10 | G-3 | - |
| Ex. 10 | B-6 | D-10 | Li-TFSI | C-12 | G-3 | - |
| Ex. 11 | B-29 | D-10 | Li-HFSI | C-12 | G-4 | - |
| Ex. 12 | B-32 | D-10 | Li-HFSI | C-12 | G-4 | - |
| Ex. 13 | B-5 | D-7 | Li-HFSI | C-10 | G-3 | F-11 |
| Ex. 14 | B-5 | D-7 | Li-HFSI | C-10 | G-3 | F-12 |
| Ex. 15 | B-5 | D-7 | Li-HFSI | C-10 | G-3 | F-16 |
| Ex. 16 | B-5 | D-7 | Li-HFSI | C-10 | G-3 | F-19 |
| Ex. 17 | B-5 | D-7 | Li-FTFSI | C-10 | G-3 | F-19 |
| Ex. 18 | B-5 | D-7 | Li-FTFSI | C-10 | G-3 | - |
| Ex. 19 | B-5 | D-7 | Li-FTFSI | C-10 | G-16 | F-19 |
| Comp. Ex. 1 | B-5 | D-7 | Li-HFSI | C-10 | - | F-11 |
| Comp. Ex. 2 | B-5 | D-7 | Li-TFSI | C-10 | Silver nitrate | - |
| Comp. Ex. 3 | B-5 | D-7 | Ag-TFSI | C-10 | G-3 | - |
| Comp. Ex. 4 | B-5 | D-7 | Li-TFSI | C-10 | - | - |
| Comp. Ex. 5 | B-5 | D-7 | - | C-10 | G-3 | - |

**[Table 2]**

| | 2,000 lux | | | | 200 lux | | | |
|---|---|---|---|---|---|---|---|---|
| | Initial | | Retention rate (%) | | Initial | | Retention rate (%) | |
| | Voc1 (V) | Pmaxl (µW/cm²) | Voc2 | Pmax2 | Voc3 (V) | Pmax3 (µW/cm²) | Voc4 | Pmax4 |
| Ex. 1 | 0.87 | 85 | 98.4 | 80.2 | 0.81 | 10.5 | 98.3 | 88.7 |
| Ex. 2 | 0.89 | 87 | 98.5 | 81.5 | 0.83 | 11.5 | 98.2 | 89.5 |
| Ex. 3 | 0.77 | 110 | 99.4 | 93.5 | 0.71 | 10.8 | 98.5 | 92.4 |
| Ex. 4 | 0.76 | 115 | 99.3 | 94.6 | 0.70 | 10.7 | 98.6 | 92.8 |
| Ex. 5 | 0.76 | 117 | 99.1 | 94.3 | 0.70 | 10.3 | 98.4 | 92.6 |
| Ex. 6 | 0.72 | 108 | 97.5 | 90.1 | 0.68 | 9.9 | 97.5 | 90.2 |
| Ex. 7 | 0.67 | 96 | 95.6 | 89.8 | 0.62 | 8.8 | 96.4 | 89.4 |
| Ex. 8 | 0.67 | 98 | 94.9 | 89.9 | 0.61 | 8.5 | 96.2 | 88.9 |
| Ex. 9 | 0.76 | 114 | 99.5 | 94.6 | 0.70 | 10.8 | 98.2 | 91.8 |
| Ex. 10 | 0.75 | 112 | 99.8 | 93.7 | 0.69 | 10.6 | 98.1 | 90.3 |
| Ex. 11 | 0.76 | 118 | 99.1 | 94.5 | 0.69 | 10.9 | 97.9 | 92.7 |
| Ex. 12 | 0.77 | 115 | 99.2 | 94.9 | 0.68 | 10.8 | 98.9 | 92.8 |
| Ex. 13 | 0.75 | 121 | 99.5 | 97.1 | 0.69 | 10.5 | 98.1 | 95.5 |
| Ex. 14 | 0.76 | 122 | 99.2 | 96.8 | 0.70 | 10.6 | 98.3 | 95.6 |
| Ex. 15 | 0.74 | 119 | 98.8 | 96.6 | 0.68 | 10.5 | 97.9 | 94.9 |
| Ex. 16 | 0.74 | 111 | 97.9 | 91.5 | 0.69 | 10.1 | 96.8 | 91.2 |
| Ex. 17 | 0.75 | 125 | 98.2 | 92.1 | 0.70 | 11.2 | 97.2 | 92.2 |
| Ex. 18 | 0.74 | 124 | 97.2 | 92.1 | 0.71 | 10.9 | 97.1 | 91.9 |
| Ex. 19 | 0.76 | 128 | 98.1 | 92.9 | 0.72 | 11.3 | 97.4 | 93.1 |
| Comp. Ex. 1 | 0.75 | 113 | 98.2 | 81.5 | 0.70 | 10.7 | 96.1 | 79.5 |
| Comp. Ex. 2 | 0.62 | 79 | 90.3 | 68.1 | 0.58 | 5.6 | 79.5 | 68.3 |
| Comp. Ex. 3 | 0.68 | 101 | 91.1 | 82.5 | 0.62 | 8.9 | 82.5 | 71.4 |
| Comp. Ex. 4 | 0.78 | 105 | 97.5 | 79.3 | 0.73 | 9.8 | 97.5 | 73.6 |
| Comp. Ex. 5 | 0.86 | 40 | 96.5 | 75.4 | 0.79 | 2.5 | 98.2 | 87.5 |

It was found from the results of Table 2 that Examples 1 to 19 had high values of Pmax4 compared to Comparative Examples 1 to 5, and therefore a reduction in output with light of low illuminance could be suppressed even after being exposed to light of high illuminance.

Moreover, Examples 13 to 16 had the particularly high retention rates. This was probably because the hypervalent iodine compound constituted the electron-accepting compound in the pores of the porous electron-transporting layer and the cobalt complex compound constituted the electron-accepting compound in the hole-transporting layer. In the case where the cobalt complex was included, moreover, it was assumed that series resistance of the hole-transporting layer decreased due to the anion component of the cobalt complex compound and therefore the initial output with light of high illuminance was improved.

Examples above will be further examined in details.

First, the electron-accepting compound was formed by mixing the hypervalent iodine compound and the hole-transporting material in the presence of the anions of the alkali metal salt. It was found that a larger amount of the electron-accepting compound was formed by mixing, particularly in the halogen-based organic solvent. The monocationic radicalized hole-transporting material was turned into a stable electron-accepting compound by anion doping. Moreover, an electron-accepting compound was similarly formed by mixing the trivalent cobalt complex and the hole-transporting material. It was assumed that the reduced divalent cobalt complex was oxidized by the hypervalent iodine compound or oxygen etc. inside the sealing and returned to the trivalent cobalt complex.

Since an electron-accepting compound could be obtained persistently, high hole-transporting function was exhibited, and high output and durability could be obtained with light of high illuminance. Specifically, an electron-accepting compound was easily formed in pores of the porous electron-transporting layer by using the hypervalent iodine compound which had the smaller molecular size than a trivalent cobalt complex used in the art, and therefore enhanced light durability.

In order to obtain high output with low illuminance, moreover, it is important to suppress current leakage. It was found that high electron-transporting capability was obtained by using, as a main component, a basic material having high compatibility to the hole-transporting material, and further using materials, such as a relatively low acidic hypervalent iodine compound, the trivalent cobalt complex, and the alkali metal salt.

### (Example 20)

### <Production of solar cell module>

On a glass substrate serving as a first substrate, a film of a film of indium-doped tin oxide (ITO) and a film of niobium-doped tin oxide (NTO) were sequentially formed by sputtering. Subsequently, a dense layer (thickness: 20 nm) formed of titanium oxide serving as a hole-blocking layer was formed by reactive sputtering with oxygen gas.

Then, part of the ITO/NTO and hole-blocking layer formed on the first substrate was etched by laser processing to make a distance between adjacent photoelectric conversion elements was to be 10 micrometers.

Next, 3 g of titanium oxide (ST-21, available from ISHIHARA SANGYO KAISHA, LTD.), 0.2 g of acetyl acetone, 0.3 g of a surfactant (polyoxyethylene octylphenyl ether, available from Wako Pure Chemical Industries, Ltd.) were subjected to a bead mill treatment together with 5.5 g of water, and 1.0 g of ethanol for 12 hours, to thereby obtain a titanium oxide dispersion liquid. To the obtained titanium oxide dispersion liquid, 1.2 g of polyethylene glycol (#20,000, available from Wako Pure Chemical Industries, Ltd.) to produce a paste. The obtained paste is applied onto the hole-blocking layer in a manner that the average thickness of the applied paste was to be about 1.5 micrometers. After drying the paste at 60 degrees Celsius, the dried paste was fired in the air for 30 minutes at 550 degrees Celsius, to thereby form a porous electron-transporting layer.

The glass substrate on which the electron-transporting layer had been formed was immersed in a solution prepared by mixing and stirring 120 mg of the photosensitizing compound (dye) represented by B-5, 150 mg of chenodeoxycholic acid (available from Tokyo Chemical Industry Co., Ltd.), and a mixed liquid of acetonitrile/t-butanol (volume ratio: 1:1), and the glass substrate was left to stand in the above-described state in the dark for 1 hour, to thereby make the photosensitizing compound adsorbed on the surface of the electron-transporting layer.

Next, to 1 mL of a chlorobenzene solution, 150 mM of a hole-transporting material represented by D-7 (available from Merck), 60 mM of lithium bis(trifluoromethanesulfonyl)imide (available from KANTO CHEMICAL CO., INC.) serving as an alkali metal salt, 130 mM of the basic compound represented by C-10, and 20 mM of the hypervalent iodine compound represented by G-4 (available from Sigma-Aldrich Co., LLC.) were added and dissolved, to thereby prepare a hole-transporting layer coating liquid.

Next, the hole-transporting layer coating liquid was applied onto the electron-transporting layer onto which the photosensitizing compound had been adsorbed by spin coating, to thereby form a hole-transporting layer having a thickness of about 500 nm. Thereafter, an edge of the glass substrate at which a sealing member was to be disposed was etched by laser processing, and a through hole that was to be a drawing terminal part and to be connected to the ITO layer was formed by laser processing. Moreover, silver was deposited thereon by vacuum vapor deposition to thereby form a second electrode having a thickness of about 100 nm. The photoelectric conversion elements adjacent to each other were formed through mask film formation in a manner that a distance between the two adjacent photoelectric conversion elements was to be 200 micrometers. It was confirmed that the silver was deposited on the inner wall of the through hole by vapor deposition and the adjacent photoelectric conversion elements were connected in series. In Example 17, 6 photoelectric conversion elements were connected in series.

An ultraviolet ray-curable resin (TB3118, available from ThreeBond Holdings Co., Ltd.) was applied onto the edge of the glass substrate to surround the power generation region by means of a dispenser (2300N, available from SAN-EI TECH Ltd.). Thereafter, the resultant was transferred into a glove box in which a dew point was controlled to minus 40 degrees Celsius and an oxygen concentration was controlled to 2.5%, and cover glass serving as a second substrate was placed on the ultraviolet-ray curable resin, and the ultraviolet-ray curable resin was cured by UV irradiation to seal the power generation region, to thereby produce the solar cell module 1 illustrated in FIG. 5. A distance between each layer in the two adjacent photoelectric conversion elements is presented in Table 3. Note that, the distance between each layer in the two adjacent photoelectric conversion elements means the minimum distance between the outer circumferences (edges) of each layer in the two adjacent photoelectric conversion elements.

### <Evaluation of solar cell module>

IV properties of the obtained solar cell module 1 was evaluated under irradiation of white LED adjusted to 3,000 lux by means of a solar cell evaluation system (As-510-PV03, available from NF Corporation), to thereby determine initial open circuit voltage Voc1 (V) and the maximum output power Pmax1 (microwatt/cm²). IV properties at 100 lux were evaluated in the similar manner to determine Voc2 and Pmax2. Subsequently, the photoelectric conversion element 1 was irradiated for 200 hours by means of a solar simulator (AM1.5, 10 mW/cm², 110,000 lux), and then IV properties at 3,000 lux and at 100 lux were again evaluated to measure the open circuit voltage and the maximum output power after the irradiation with light of high illuminance. Then, a retention rate of the open circuit voltage and a retention rate of the maximum output power were determined. The results are presented in Table 4.

### (Example 21)

A solar cell module 2 was produced in Example 21 in the same manner as in Example 20, except that a distance between the first electrode in the photoelectric conversion element and the first electrode in the adjacent photoelectric conversion element and a distance between the hole-blocking layer in the photoelectric conversion element and the hole-blocking layer in the adjacent photoelectric conversion element were both set to 200 micrometers. A distance between each layer in the two adjacent photoelectric conversion elements is presented in Table 3. Then, Voc1, Pmax1, Voc2, Pmax2, and retention rates of the obtained solar cell module 2 were determined in the same manner as in Example 20. The results are presented in Table 4.

### (Example 22)

A solar cell module 3 was produced in Example 22 in the same manner as in Example 20, except that a distance between the electron-transporting layer in the photoelectric conversion element and the electron-transporting layer in the adjacent photoelectric conversion element was set to 10 micrometers. A distance between each layer in the two adjacent photoelectric conversion elements is presented in Table 3. Then, Voc1, Pmax1, Voc2, Pmax2, and retention rates of the obtained solar cell module 3 were determined in the same manner as in Example 20. The results are presented in Table 4.

**[Table 3]**

| | Distance between identical layer in adjacent photoelectric conversion elements | | | | |
|---|---|---|---|---|---|
| | First electrode | Hole-blocking layer | Electron-transporting layer | Hole-transporting layer | Second electrode |
| Ex. 20 | 10 µm | 10 µm | Linked | Linked | 200 µm |
| Ex. 21 | 200 µm | 200 µm | Linked | Linked | 200 µm |
| Ex. 22 | 10 µm | 10 µm | 10 µm | Linked | 200 µm |

**[Table 4]**

| | Initial | | Retention rate (%) | | Initial | | Retention rate (%) | |
|---|---|---|---|---|---|---|---|---|
| | Voc1 (V) | Pmax1 (µW/cm²) | Voc2 | Pmax2 | Voc3 (V) | Pmax3 (µW/cm²) | Voc4 | Pmax4 |
| Ex. 20 | 5.02 | 150.3 | 94.2 | 92.2 | 4.12 | 4.97 | 89.5 | 86.1 |
| Ex. 21 | 5.11 | 157.8 | 95.1 | 93.9 | 4.36 | 5.16 | 91.4 | 90.3 |
| Ex. 22 | 5.16 | 160.2 | 95.9 | 93.8 | 4.46 | 5.27 | 93.6 | 91.2 |

It was found from the results of Table 4 that Examples 20 to 22 had high values of Pmax4, and therefore a reduction in output with light of low illuminance could be suppressed even after being exposed to light of high illuminance.

As described above, the photoelectric conversion element of the present disclosure includes at least a first electrode, an electron-transporting layer, a hole-transporting layer, and a second electrode, where the hole-transporting layer includes at least a hole-transporting material, an alkali metal salt, and a hypervalent iodine compound. Therefore, the photoelectric conversion element of the present disclosure can suppress a reduction in output thereof with light of low illuminance even after being exposed to light of high illuminance.

### Reference Signs List

1: first substrate
2, 2a, 2b: first electrode
3: hole-blocking layer
4: electron-transporting layer
5: photosensitizing compound
6: hole-transporting layer
7, 7a, 7b: second electrode
8: sealing member
9: second substrate
10: through part (conductive part)
11: sealing member
101: photoelectric conversion element
102: solar cell module

## Claims

1. A photoelectric conversion element comprising:
a first electrode;
an electron-transporting layer;
a hole-transporting layer; and
a second electrode,
**characterized in that**
the hole-transporting layer includes a hole-transporting material, an alkali metal salt, and a hypervalent iodine compound.

2. The photoelectric conversion element according to claim 1,
wherein the hypervalent iodine compound includes a periodinane compound, or a diaryliodonium salt, or both.

3. The photoelectric conversion element according to claim 2,
wherein the periodinane compound is a compound represented by General Formula (1) below, 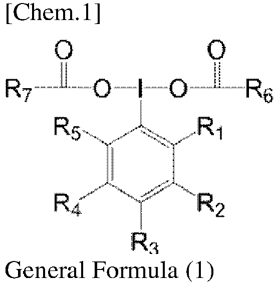 where, in General Formula (1), R₁ to R₅ are each a hydrogen atom, a methyl group, or a fluorine atom, and R₆ and R₇ are each a methyl group or a trifluoromethyl group.

4. The photoelectric conversion element according to claim 2,
wherein the diaryliodonium salt is a compound represented by General Formula (2) below, 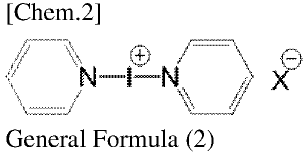 where, in General Formula (2), X is a compound represented by any one of Structural Formulae (1) to (4) below,

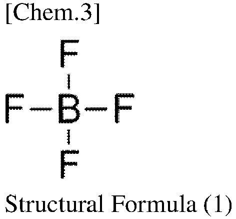

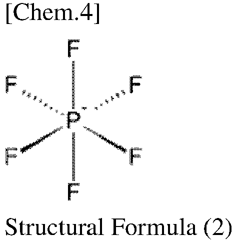

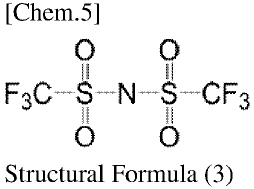

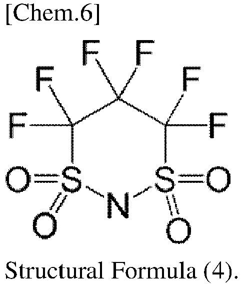

5. The photoelectric conversion element according to claim 2,
wherein the diaryliodonium salt is a compound represented by General Formula (9) below, 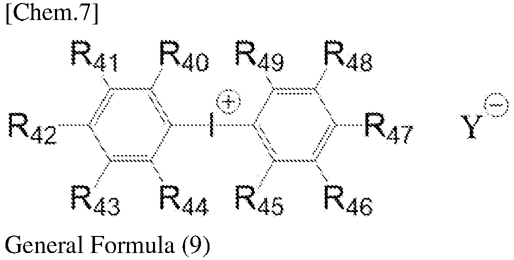 where, in General Formula (9), R₄₀ to R₄₈ are each a hydrogen atom, a fluorine atom, a methyl group, a trifluoromethyl group, a methoxy group, an isopropyl group, or a tertiary butyl group, and Y is a compound represented by any one of Structural Formulae (8) to (10) below,

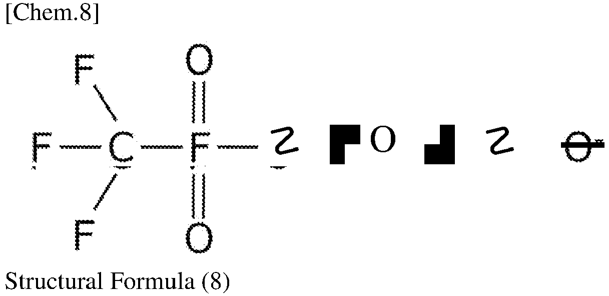

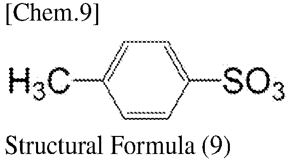

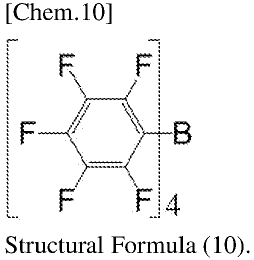

6. The photoelectric conversion element according to any one of claims 1 to 5,
wherein the hole-transporting layer further includes a basic compound represented by General Formula (3) below, or a basic compound represented by General Formula (4) below, or both, 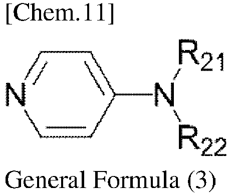 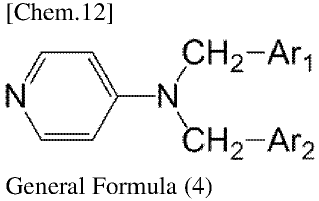 where, in General Formula (3), R₂₁ and R₂₂ are each an alkyl group or an aromatic hydrocarbon group, or a nitrogen atom-including heterocyclic group formed by bonding R₂₁ and R₂₂ together, and in General Formula (4), Ar₁ and Ar₂ are each an aryl group that may include a substituent.

7. The photoelectric conversion element according to any one of claims 1 to 6,
wherein the hole-transporting layer further includes a trivalent cobalt complex compound represented by General Formula (5) below, 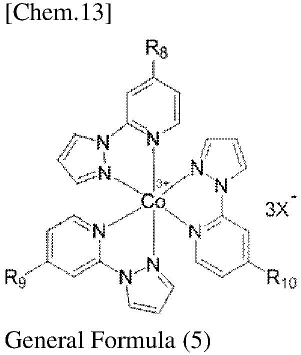 where, in General Formula (5), R₈ to R₁₀ are each a methyl group, an ethyl group, a tertiary butyl group, or a trifluoromethyl group, and X is a compound represented by any one of Structural Formulae (1) to (4) below,

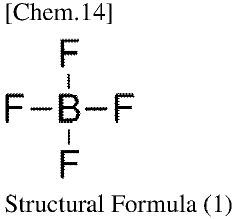

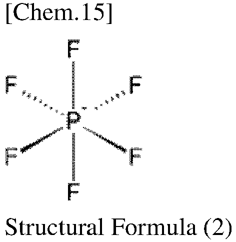

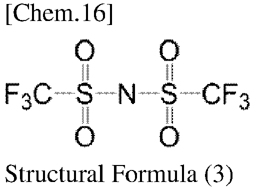

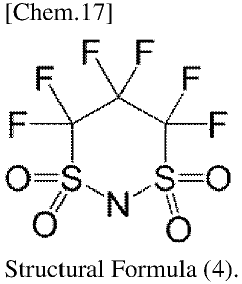

8. The photoelectric conversion element according to any one of claims 1 to 7,
wherein the electron-transporting layer is a porous layer including titanium oxide particles on each of which a photosensitizing compound is adsorbed.

9. The photoelectric conversion element according to any one of claims 1 to 8,
wherein the hole-transporting layer includes lithium (fluorosulfonyl)(trifluoromethanesulfonyl)imide.

10. The photoelectric conversion element according to any one of claims 1 to 9,
wherein the hole-transporting material is a compound represented by General Formula (7) below, 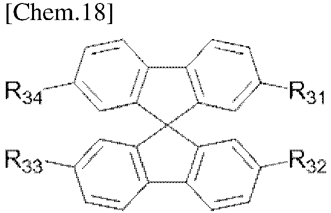 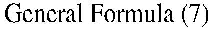 wherein, in General Formula (7), R₃₁ to R₃₄ are each a dimethylamino group, a diphenylamino group, or a naphthyl-4-tolylamino group.

11. The photoelectric conversion element according to any one of claims 1 to 10, further comprising:
a hole-blocking layer disposed between the first electrode and the electron-transporting layer.

12. A solar cell module comprising:
a plurality of the photoelectric conversion elements according to any one of claims 1 to 11.

13. The solar cell module according to claim 12,
wherein each of the photoelectric conversion elements includes a hole-blocking layer, and
among at least two photoelectric conversion elements adjacent to each other, the hole-transporting layer of the photoelectric conversion element is extended to the hole-transporting layer of the adjacent photoelectric conversion element, and
the hole-blocking layer of the photoelectric conversion element is not extended to the hole-blocking layer of the adjacent photoelectric conversion element.

14. A power supply module comprising:
the photoelectric conversion element according to any one of claims 1 to 11, or the solar cell module according to claim 12 or 13, or both; and
a power supply circuit.

15. An electronic device comprising:
at least one selected from the group consisting of the photoelectric conversion element according to any one of claims 1 to 11, the solar cell module according to claim 12 or 13, and the power supply module according to claim 14; and
a device configured to be driven by electricity generated by at least one selected from the group consisting of the photoelectric conversion element, the solar cell module, and the power supply module.

## Patentansprüche

1. Element zur fotoelektrischen Umwandlung, Folgendes umfassend:
eine erste Elektrode;
eine Elektronentransportschicht;
eine Lochtransportschicht; und
eine zweite Elektrode,
**dadurch gekennzeichnet, dass**
die Lochtransportschicht ein Lochtransportmaterial, ein Alkalimetallsalz und eine hypervalente Jodverbindung einschließt.

2. Element zur fotoelektrischen Umwandlung nach Anspruch 1, wobei die hypervalente Jodverbindung eine Periodinanverbindung oder ein Diaryliodoniumsalz oder beides einschließt.

3. Element zur fotoelektrischen Umwandlung nach Anspruch 2,
wobei die Periodinanverbindung eine Verbindung ist, dargestellt durch die nachstehende Allgemeine Formel (1), 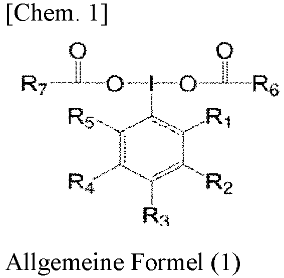 wobei in der Allgemeinen Formel (1), R₁ bis R₅ jeweils ein Wasserstoffatom, eine Methylgruppe, oder ein Fluoratom sind, und R₆ und R₇ jeweils eine Methylgruppe oder eine Trifluormethylgruppe sind.

4. Element zur fotoelektrischen Umwandlung nach Anspruch 2,
wobei das Diaryliodoniumsalz eine Verbindung ist, dargestellt durch die nachstehende Allgemeine Formel (2), 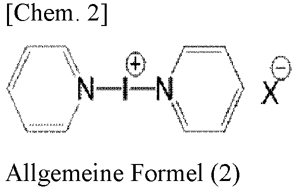 wobei, in der Allgemeinen Formel (2), X eine Verbindung ist, dargestellt durch eine der nachstehenden Strukturellen Formeln (1) bis (4),

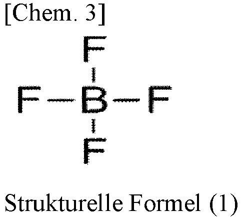

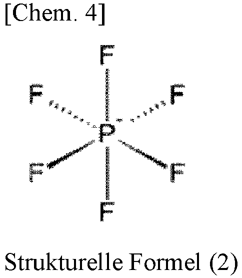

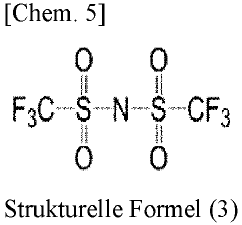

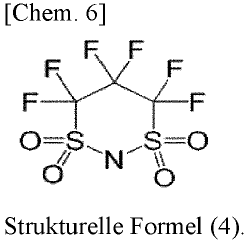

5. Element zur fotoelektrischen Umwandlung nach Anspruch 2,
wobei das Diaryliodoniumsalz eine Verbindung ist, dargestellt durch die nachstehende Allgemeine Formel (9), 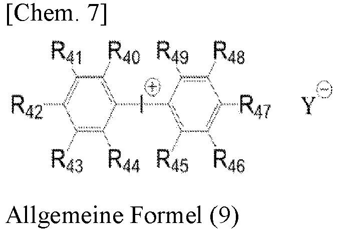 wobei, in der Allgemeinen Formel (9), R₄₀ bis R₄₈ jeweils ein Wasserstoffatom, ein Fluoratom, eine Methylgruppe, eine Trifluormethylgruppe, eine Methoxygruppe, eine Isopropylgruppe oder eine tertiäre Butylgruppe sind, und Y eine Verbindung ist, dargestellt durch eine der nachstehenden Strukturellen Formeln (8) bis (10),

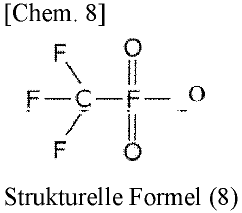

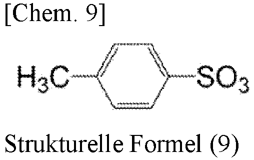

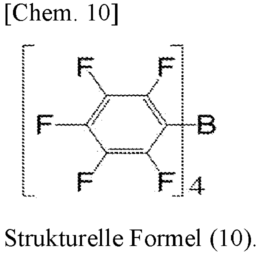

6. Element zur fotoelektrischen Umwandlung nach einem der Ansprüche 1 bis 5,
wobei die Lochtransportschicht ferner eine basische Verbindung einschließt, dargestellt durch die nachstehende Allgemeine Formel (3), oder eine basische Verbindung, dargestellt durch die nachstehende Allgemeine Formel (4), oder durch beide, 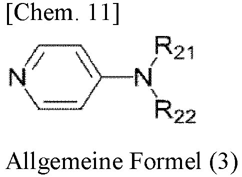 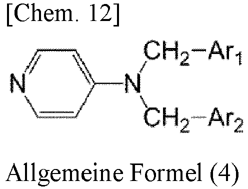 wobei, in der Allgemeinen Formel (3), R₂₁ und R₂₂ jeweils eine Alkylgruppe oder eine aromatische Kohlenwasserstoffgruppe, oder eine ein Stickstoffatom einschließende heterozyklische Gruppe sind, gebildet durch Verbinden von R₂₁ und R₂₂ miteinander, und in der Allgemeinen Formel (4), Ar₁ und Ar₂ jeweils eine Arylgruppe sind, welche einen Substituenten einschließen kann.

7. Element zur fotoelektrischen Umwandlung nach einem der Ansprüche 1 bis 6,
wobei die Lochtransportschicht ferner eine dreiwertige Kobaltkomplexverbindung einschließt, dargestellt durch die nachstehende Allgemeine Formel (5), 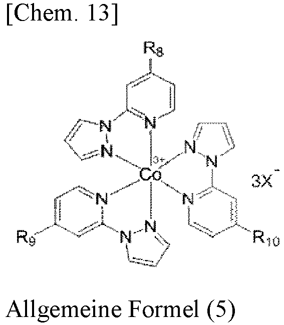 wobei, in der Allgemeinen Formel (5), R₈ bis R₁₀ jeweils eine Methylgruppe, eine Ethylgruppe, eine tertiäre Butylgruppe oder eine Trifluormethylgruppe sind, und X eine Verbindung ist, dargestellt durch eine der nachstehenden Strukturellen Formeln (1) bis (4),

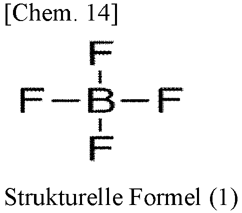

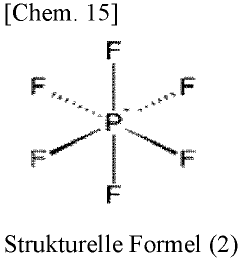

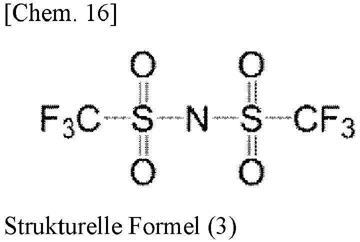

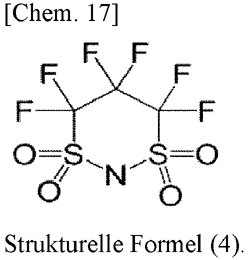

8. Element zur fotoelektrischen Umwandlung nach einem der Ansprüche 1 bis 7,
wobei die Elektronentransportschicht eine poröse Schicht ist, welche Titanoxidpartikel einschließt, an welchen jeweils eine fotosensibilisierende Verbindung adsorbiert ist.

9. Element zur fotoelektrischen Umwandlung nach einem der Ansprüche 1 bis 8,
wobei die Lochtransportschicht Lithium(fluorsulfonyl)(trifluormethansulfonyl)imid einschließt.

10. Element zur fotoelektrischen Umwandlung nach einem der Ansprüche 1 bis 9,
wobei das Lochtransportmaterial eine Verbindung ist, dargestellt durch die nachstehende Allgemeine Formel (7), 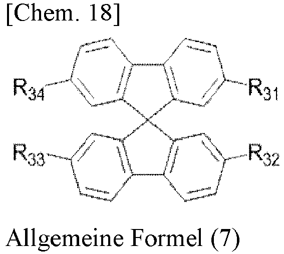 wobei, in der Allgemeinen Formel (7), R₃₁ bis R₃₄ jeweils eine Dimethylaminogruppe, eine Diphenylaminogruppe oder eine Naphthyl-4-tolylaminogruppe sind.

11. Element zur fotoelektrischen Umwandlung nach einem der Ansprüche 1 bis 10, ferner umfassend:
eine Lochsperrschicht, welche zwischen der ersten Elektrode und der Elektronentransportschicht angeordnet ist.

12. Solarzellenmodul, Folgendes umfassend:
eine Vielzahl der Elemente zur fotoelektrischen Umwandlung nach einem der Ansprüche 1 bis 11.

13. Solarzellenmodul nach Anspruch 12,
wobei jedes der Elemente zur fotoelektrischen Umwandlung eine Lochsperrschicht einschließt, und
unter mindestens zwei Elementen zur fotoelektrischen Umwandlung, welche zueinander benachbart sind, sich die Lochtransportschicht des Elements zur fotoelektrischen Umwandlung auf die Lochtransportschicht des benachbarten Elements zur fotoelektrischen Umwandlung erstreckt, und
die Lochsperrschicht des Elements zur fotoelektrischen Umwandlung sich nicht bis zu der Lochsperrschicht des benachbarten Elements zur fotoelektrischen Umwandlung erstreckt.

14. Stromversorgungsmodul, Folgendes umfassend:
das Element zur fotoelektrischen Umwandlung nach einem der Ansprüche 1 bis 11 oder das Solarzellenmodul nach Anspruch 12 oder 13, oder beide; und
eine Stromversorgungsschaltung.

15. Elektronische Vorrichtung, Folgendes umfassend:
mindestens eines, ausgewählt aus der Gruppe, bestehend aus dem Element zur fotoelektrischen Umwandlung nach einem der Ansprüche 1 bis 11, dem Solarzellenmodul nach Anspruch 12 oder 13, und dem Stromversorgungsmodul nach Anspruch 14; und
eine Vorrichtung, welche konfiguriert ist, um durch Elektrizität angetrieben zu werden, welche durch mindestens eines erzeugt wird, ausgewählt aus der Gruppe, bestehend aus dem Element zur fotoelektrischen Umwandlung, dem Solarzellenmodul und dem Stromversorgungsmodul.

## Revendications

1. Élément de conversion photoélectrique comprenant :
une première électrode ;
une couche de transport d'électrons ;
une couche de transport de trou ; et
une seconde électrode ;
**caractérisé en ce que**
la couche de transport de trou inclut un matériau de transport de trou, un sel de métal alcalin, et un composé d'iode hypervalent.

2. Élément de conversion photoélectrique selon la revendication 1, dans lequel le composé d'iode hypervalent inclut un composé de périodinane, ou un sel de diaryliodonium, ou les deux.

3. Élément de conversion photoélectrique selon la revendication 2,
dans lequel le composé de périodinane est un composé représenté par la Formule Générale (1) ci-dessous, 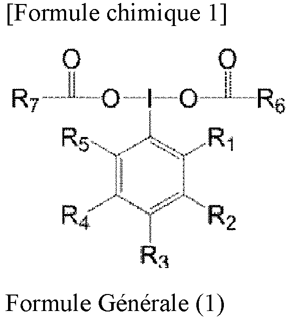 dans lequel, dans la Formule Générale (1), R₁ à R₅ sont chacun un atome d'hydrogène, un groupe méthyle, ou un atome de fluor, et R₆ et R₇ sont chacun un groupe méthyle ou un groupe trifluorométhyle.

4. Élément de conversion photoélectrique selon la revendication 2,
dans lequel le sel diaryliodonium est un composé représenté par la Formule Générale (2) ci-dessous, 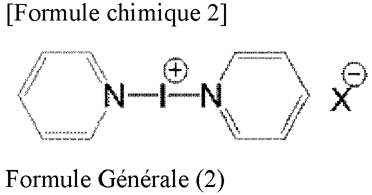 dans lequel, dans la Formule Générale (2), X est un composé représenté par l'une quelconque des Formules Structurelles (1) à (4) ci-dessous,

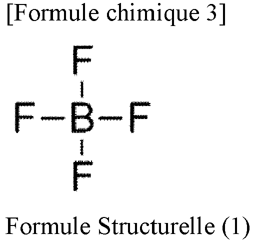

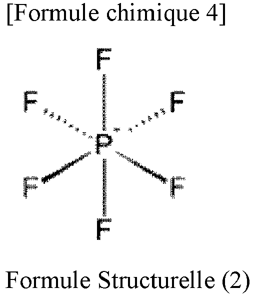

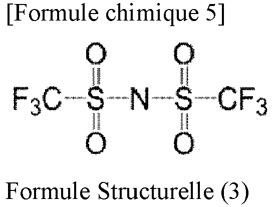

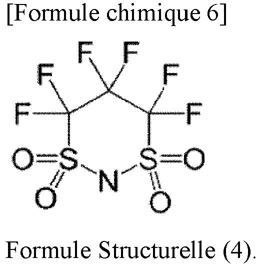

5. Élément de conversion photoélectrique selon la revendication 2,
dans lequel le sel de diaryliodonium est un composé représenté par la Formule Générale (9) ci-dessous, 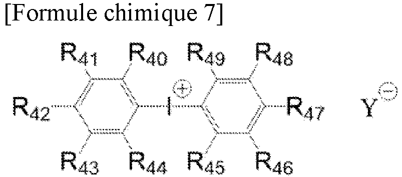 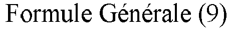 dans lequel, dans la Formule Générale (9), R₄₀ à R₄₈ sont chacun un atome d'hydrogène, un atome de fluor, un groupe méthyle, un groupe trifluorométhyle, un groupe méthoxy, un groupe isopropyle, ou un groupe butyle tertiaire, et Y est un composé représenté par l'une quelconque des Formules Structurelles (8) à (10) ci-dessous,

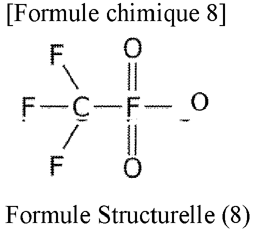

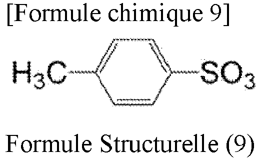

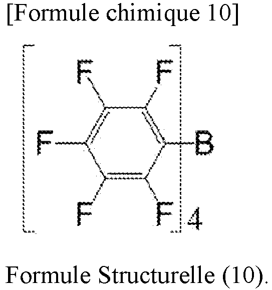

6. Élément de conversion photoélectrique selon l'une quelconque des revendications 1 à 5,
dans lequel la couche de transport de trou inclut en outre un composé basique représenté par la Formule Générale (3) ci-dessous, ou un composé basique représenté par la Formule Générale (4) ci-dessous, ou les deux, 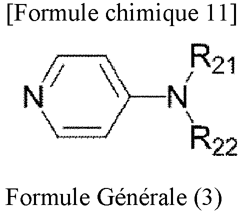 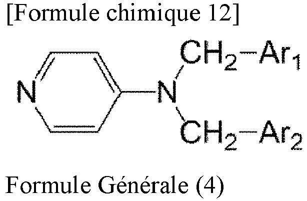 dans lequel, dans la Formule Générale (3), R₂₁ et R₂₂ sont chacun un groupe alkyle ou un groupe hydrocarbure aromatique, ou un groupe hétérocyclique incluant un atome d'azote, formé par liaison de R₂₁ et R₂₂ ensemble, et dans la Formule Générale (4), Ar₁ et Ar₂ sont chacun un groupe aryle qui peut inclure un substituant.

7. Élément de conversion photoélectrique selon l'une quelconque des revendications 1 à 6,
dans lequel la couche de transport de trou inclut en outre un composé complexe de cobalt trivalent représenté par la Formule Générale (5) ci-dessous, 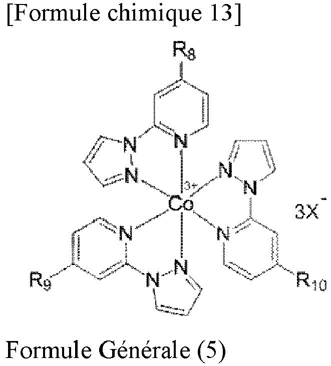 dans lequel, dans la Formule Générale (5), R₈ à R₁₀ sont chacun un groupe méthyle, un groupe éthyle, un groupe butyle tertiaire, ou un groupe trifluorométhyle, et X est un composé représenté par l'une quelconque des Formules Structurelles (1) à (4) ci-dessous,

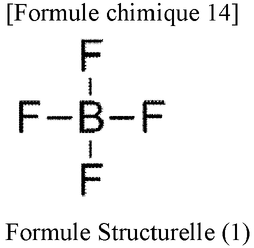

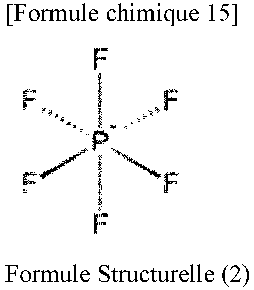

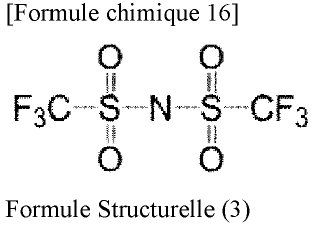

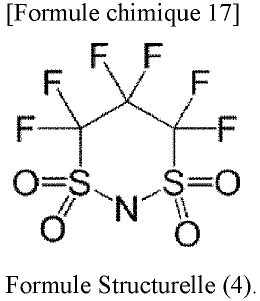

8. Élément de conversion photoélectrique selon l'une quelconque des revendications 1 à 7,
dans lequel la couche de transport d'électrons est une couche poreuse incluant des particules d'oxyde de titane sur chacune desquelles un composé photosensibilisant est adsorbé.

9. Élément de conversion photoélectrique selon l'une quelconque des revendications 1 à 8,
dans lequel la couche de transport de trou inclut du (fluorosulfonyl)(trifluorométhanesulfonyl)imide de lithium.

10. Élément de conversion photoélectrique selon l'une quelconque des revendications 1 à 9,
dans lequel le matériau de transport de trou est un composé représenté par la Formule Générale (7) ci-dessous, 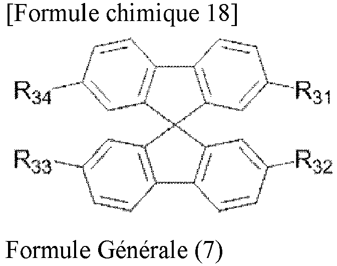 dans lequel, dans la Formule Générale (7), R₃₁ à R₃₄ sont chacun un groupe diméthylamino, un groupe diphénylamino, ou un groupe naphtyl-4-tolylamino.

11. Élément de conversion photoélectrique selon l'une quelconque des revendications 1 à 10, comprenant en outre :
une couche de blocage de trou disposée entre la première électrode et la couche de transport d'électrons.

12. Module de cellule solaire comprenant :
une pluralité des éléments de conversion photoélectrique selon l'une quelconque des revendications 1 à 11.

13. Module de cellule solaire selon la revendication 12,
dans lequel chacun des éléments de conversion photoélectrique inclut une couche de blocage de trou, et
parmi au moins deux éléments de conversion photoélectriques adjacents l'un à l'autre, la couche de transport de trou de l'élément de conversion photoélectrique est étendue à la couche de transport de trou de l'élément de conversion photoélectrique adjacent, et
la couche de blocage de trou de l'élément de conversion photoélectrique n'est pas étendue à la couche de blocage de trou de l'élément de conversion photoélectrique adjacent.

14. Module d'alimentation électrique, comprenant :
l'élément de conversion photoélectrique selon l'une quelconque des revendications 1 à 11, ou le module de cellule solaire selon la revendication 12 ou 13, ou les deux ; et
un circuit d'alimentation électrique.

15. Dispositif électronique comprenant :
au moins l'un sélectionné parmi le groupe constitué de l'élément de conversion photoélectrique selon l'une quelconque des revendications 1 à 11, le module de cellule solaire selon la revendication 12 ou 13, et le module d'alimentation électrique selon la revendication 14 ; et
un dispositif configuré pour être entraîné par l'électricité générée par au moins l'un sélectionné parmi le groupe constitué de l'élément de conversion photoélectrique, du module de cellule solaire et du module d'alimentation électrique.
